# EUROPEAN PATENT APPLICATION

(11) **EP 4 760 693 A1**
(43) Date of publication of application: **17.06.2026**
(21) Application number: 23962619.5
(22) Date of filing: 27.12.2023
(51) Int. Cl.: G09G 3/3225

(54) **DISPLAY MODULE AND DISPLAY APPARATUS**

(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: LU, Yanwei, Beijing 100176 (CN); DENG, Jiangtao, Beijing 100176 (CN); YAN, Zhuoran, Beijing 100176 (CN); CHENG, Yudiao, Beijing 100176 (CN); LI, Huatao, Beijing 100176 (CN); JI, Fengli, Beijing 100176 (CN); ZHENG, Hai, Beijing 100176 (CN)
(74) Representative: Durán-Corretjer, S.L.P.
(86) International application number: PCT/CN2023/142368
(87) International publication number: WO 2025/137931

(57) **Abstract**

A display module and a display apparatus. The display module comprises a display substrate (10) and a first structure layer (11); on the plane parallel to the display substrate (10), the display substrate (10) comprises a display area (AA) and a frame area (BB), the frame area (BB) is located around the display area (AA), the frame area (BB) is provided with at least one type of first gate driving circuits (GOA1), there are a plurality of first gate driving circuits (GOA1) of the same type, and the first gate driving circuits (GOA1) comprise a plurality of transistors; in a direction (Z) perpendicular to the plane where the display substrate is located, the first structure layer (11) is provided on a backlight side (S2) of the display substrate (10), the orthographic projection of the first structure layer (11) on the display substrate (10) at least covers part of the display area (AA), and at least some transistors in the plurality of first gate driving circuits (GOA1) of the same type have the same range covered by the orthographic projection of the first structure layer (11) on the display substrate (10).

## Description

### Technical Field

The present disclosure relates to, but is not limited to, the field of display technologies, and particularly to a display module and a display apparatus.

### Background

An Organic Light Emitting Diode (OLED for short) and a Quantum dot Light Emitting Diode (QLED for short) are active light emitting display devices and have advantages such as self-luminescence, wide viewing angle, high contrast ratio, low power consumption, very high response speed, lightness and thinness, flexibility, and low cost. With continuous development of display technologies, a display apparatus in which an OLED or a QLED is used as a light emitting device and a Thin Film Transistor (TFT) is used for signal control has become a mainstream product in the field of display at present.

### Summary

The following is a summary of subject matters described herein in detail. This summary is not intended to limit the protection scope of claims.

In the first aspect, an embodiment of the present disclosure provides a display module, including a display substrate and a first structure layer, and on a plane parallel to the display substrate, the display substrate includes a display region and a bezel region, the bezel region is located around the display region, wherein the bezel region is provided with first gate driving circuits of at least one type, the number of first gate driving circuits of the same type is a plurality, and the first gate driving circuit includes a plurality of transistors; in a direction perpendicular to a plane of the display substrate, the display substrate includes an light exiting side and a backlight side, wherein the first structure layer is arranged on the backlight side of the display substrate, and an orthographic projection of the first structure layer on the display substrate covers at least a part of the display region, and ranges of at least a part of the transistors in a plurality of first gate driving circuits of the same type covered by an orthographic projection of the first structure layer on the display substrate are consistent.

In an exemplary implementation, a plurality of first gate driving circuits of the same type are arranged along an extension direction of the bezel region.

In an exemplary implementation, the display region includes a plurality of rows of sub-pixels, and the sub-pixel at least includes a pixel driving circuit, which includes at least one type of an oxide transistor; the first gate driving circuit is electrically connected to a control electrode of the at least one type of the oxide transistor in at least one row of sub-pixels and configured to provide scan signals to the at least one type of the oxide transistor in the at least one row of sub-pixels.

In an exemplary implementation, a plurality of transistors in the first gate driving circuit at least include a low-level output transistor and a low-level output control transistor, and the low-level output transistor is configured to output low-level signals to the at least one type of the oxide transistor in the at least one row of sub-pixels under the control of the low-level output control transistor;
ranges of the low-level output transistors in a plurality of first gate driving circuits of the same type covered by the orthographic projection of the first structure layer on the display substrate are consistent; and ranges of the low-level output control transistors in a plurality of first gate driving circuits of the same type covered by the orthographic projection of the first structure layer on the display substrate are consistent.

In an exemplary implementation, there is no overlapping area between the orthographic projection of the first structure layer on the display substrate and a plurality of first gate driving circuits of at least one type.

In an exemplary implementation, an orthographic projection of an edge of the first structure layer on the display substrate is located in a first region; on a plane parallel to the display substrate, the first region is located between edges of the plurality of first gate driving circuits of the at least one type close to the display region and an edge of the display region close to the bezel region, and the orthographic projection of the first structure layer on the display substrate covers the display region; or
there is no overlapping area between the orthographic projection of the first structure layer on the display substrate and the bezel region, and the orthographic projection of the first structure layer on the display substrate is located within a range of the display region or overlapped with the display region.

In an exemplary implementation, on a plane parallel to the display substrate and along a direction from the display region to the bezel region, a distance between an edge of the first structure layer and an edge of the display substrate is 700 microns to 1200 microns, which is greater than a distance between edges of first gate driving circuits of at least one type close to the display region and an edge of the display substrate.

In an exemplary implementation, the orthographic projection of the first structure layer on the display substrate covers the display region and a plurality of first gate driving circuits of at least one type.

In the exemplary implementation, the bezel region is also provided with second gate driving circuits of at least one type, the number of the second gate driving circuits of the same type is a plurality; on a plane parallel to the display substrate, the plurality of second gate driving circuits of the same type are arranged along an extension direction of the bezel region, and along an direction from the display region to the bezel region, the plurality of second gate driving circuits of at least one type are located between the plurality of first gate driving circuits of the at least one type and the display region .

In an exemplary implementation, on a plane parallel to the display substrate and in a direction from the display region to the bezel region, a distance between an edge of the first structure layer and an edge of the display substrate is 100 microns to 350 microns, which is less than a distance between edges of first gate driving circuits of at least one type away from the display region and an edge of the display substrate.

In the exemplary implementation, the bezel region is also provided with second gate driving circuits of at least one type, the number of the second gate driving circuits of the same type is a plurality; on a plane parallel to the display substrate, the plurality of second gate driving circuits of the same type are arranged along an extension direction of the bezel region, and along an direction from the display region to the bezel region, the plurality of second driving circuits of at least one type are located on side of the plurality of first driving circuits of the at least one type away from the display region.

In an exemplary implementation, on a plane parallel to the display substrate and in a direction from the display region to the bezel region, a distance between an edge of the first structure layer and an edge of the display substrate is 500 microns to 700 microns, which is less than a distance between edges of first gate driving circuits of at least one type away from the display region and an edge of the display substrate.

In an exemplary implementation, the first structure layer includes a first connection structure layer, a buffer structure layer, and a heat dissipation structure layer arranged on the backlight sides sequentially, wherein there is no overlapping area between an orthographic projection of the heat dissipation structure layer on the display substrate and a plurality of first gate driving circuits of at least one type, or the orthographic projection of the heat dissipation structure layer on the display substrate covers the plurality of first gate driving circuits of the at least one type.

In an exemplary implementation, the orthographic projection of the first structure layer on the display substrate at least covers at least one of low-level output transistors and low-level output control transistors in a plurality of first gate driving circuits of at least one type.

In an exemplary implementation, on a plane parallel to the display substrate and along a direction from the display region to the bezel region, the low-level output control transistor is located on a side of the low-level output transistor away from the display region, a length dimension of first gate driving circuits of at least one type has 120 microns to 150 microns, and the low-level output control transistor and the low-level output transistor are located on both sides of a centerline of the first gate driving circuit along an extension direction of the bezel region;
in a structure in which the orthographic projection of the first structure layer on the display substrate at least covers low-level output transistors and low-level output control transistors in a plurality of first gate driving circuits of at least one type, a length dimension of the orthographic projection of the first structure layer on the display substrate covering the first gate driving circuits of the at least one type is 100 microns to 150 microns along a direction from the display region to the bezel region; and
in a structure in which the orthographic projection of the first structure layer on the display substrate at least covers low-level output transistors in a plurality of first gate driving circuits of at least one type, a length dimension of the orthographic projection of the first structure layer on the display substrate covering the first gate driving circuits of the at least one type is 40 microns to 95 microns along a direction from the display region to the bezel region.

In an exemplary implementation, second gate driving circuits of at least one type is also provided in the bezel region, and on a plane parallel to the display substrate, a plurality of second gate driving circuits of the same type are arranged along an extension direction of the bezel region; and
in a direction from the display region to the bezel region, the plurality of second gate driving circuits of the at least one type are located on a side of the plurality of first gate driving circuits of the at least one type away from the display region, or the plurality of second gate driving circuits of the at least one type are located between the plurality of first gate driving circuits of the at least one type and the display region.

In an exemplary implementation, the display substrate includes a shielding structure layer, and in a direction perpendicular to a plane on which the display substrate is located, the shielding structure layer is located on a side of the first gate driving circuit away from the light exiting side, and the shielding structure layer at least includes at least one shielding structure of a first shielding structure and a second shielding structure;
the number of the first shielding structures is a plurality, and the plurality of first shielding structures are respectively configured to shield low-level output control transistors in a plurality of first gate driving circuits of at least one type; and the number of the second shielding structures is a plurality, and the plurality of second shielding structures are respectively configured to shield low-level output transistors in a plurality of first gate driving circuits of at least one type.

In a second aspect, an embodiment of the present disclosure also provides a display module, including a display substrate; on a plane parallel to the display substrate, the display substrate includes a display region and a bezel region, which is located around the display region and is provided with first gate driving circuits of at least one type; the number of first gate driving circuits of the same type is a plurality, and the first gate driving circuit includes a plurality of transistors; in a direction perpendicular to a plane on which the display substrate is located, the display substrate includes a light exiting side and a backlight side, and a shielding structure layer is provided on a side of the first gate driving circuit away from the light exiting side, and ranges of a plurality of first gate driving circuits of the same type shielded by the shielding structure layer are consistent.

In an exemplary implementation, a plurality of first gate driving circuits of the same type are arranged along an extension direction of the bezel region.

In an exemplary implementation, the display region includes a plurality of rows of sub-pixels, and the sub-pixel at least includes a pixel driving circuit, which includes at least one type of an oxide transistor; the first gate driving circuit is electrically connected to a control electrode of the at least one type of the oxide transistor in at least one row of sub-pixels and configured to provide scan signals to the at least one type of the oxide transistor in the at least one row of sub-pixels.

In an exemplary implementation, a plurality of transistors in the first gate driving circuit at least include a low-level output transistor and a low-level output control transistor, and the low-level output transistor is configured to output low-level signals to the at least one type of the oxide transistor in the at least one row of sub-pixels under the control of the low-level output control transistor;
ranges of low-level output transistors in a plurality of first gate driving circuits of the same type shielded by the shielding structure layer are consistent; and ranges of low-level output control transistors in a plurality of first gate driving circuits of the same type shielded by the shielding structure layer are consistent.

In an exemplary implementation, the shielding structure layer at least includes at least one shielding structure of a first shielding structure and a second shielding structure;
the number of the first shielding structures is a plurality, and the plurality of first shielding structures are respectively configured to shield low-level output control transistors in a plurality of first gate driving circuits of at least one type; and the number of the second shielding structures is a plurality, and the plurality of second shielding structures are respectively configured to shield low-level output transistors in a plurality of first gate driving circuits of at least one type.

In a third aspect, an embodiment of the present disclosure also provides a display apparatus including the display module described in any of the above embodiments.

Other aspects of the present disclosure may be comprehended after the drawings and the detailed descriptions are read and understood.

### Brief Description of Drawings

Accompanying drawings are used for providing further understanding of technical solutions of embodiments of the present disclosure, constitute a portion of the specification, and are used for explaining the technical solutions of the present disclosure together with embodiments of the present disclosure, but do not constitute limitations on the technical solutions of the present disclosure. Shapes and sizes of each component in the drawings do not reflect actual scales, but are only intended to schematically illustrate contents of the present disclosure.
FIG. 1 is a schematic diagram of a structure of a display apparatus.
FIG. 2 is a schematic diagram of a planar structure of a display substrate.
FIG. 3 is a schematic diagram of a sectional structure of a display region in a display substrate.
FIG. 4 is an equivalent circuit diagram of a pixel driving circuit.
FIG. 5 is an equivalent circuit diagram of a pixel driving circuit.
FIG. 6 is a schematic diagram of a structure of a display substrate according to an exemplary implementation of the present disclosure.
FIG. 7 is a schematic diagram of a cross-section structure of the A1-A1 position in FIG. 6.
FIG. 8a shows a schematic diagram of a structure of a display substrate according to an exemplary implementation of the present disclosure.
FIG. 8b is a schematic diagram of a cross-section structure at a position A2-A2 in FIG. 8a.
FIG. 9 is a schematic diagram of a cross-section structure of the A1-A1 position in FIG. 6.
FIG. 10 is a schematic diagram of a cross-section structure of the A1-A1 position in FIG. 6.
FIG. 11 is a schematic diagram of a cross-section structure of the A1-A1 position in FIG. 6.
FIG. 12 is a schematic diagram of a cross-section structure of the A1-A1 position in FIG. 6.
FIG. 13 is a schematic diagram of a cross-section structure of the A1-A1 position in FIG. 6.
FIG. 14 is a schematic diagram of a cross-section structure of the A1-A1 position in FIG. 6.
FIG. 15 is a schematic diagram of a cross-section structure of the A1-A1 position in FIG. 6.
FIG. 16 is a schematic diagram of a cross-section structure of the A1-A1 position in FIG. 6.
FIGS. 17a to 17e are equivalent circuit diagrams of several first gate driving circuits according to an exemplary implementation of the present disclosure.
FIG. 18 is a schematic diagram of a shielding structure layer according to an exemplary implementation of the present disclosure.
FIG. 19 is a schematic diagram of a cross-section structure of the A3-A3 position in FIG. 6.
FIG. 20a is a schematic diagram of a structure of a first gate driving circuit according to an exemplary implementation of the present disclosure.
FIG. 20b is a schematic diagram of a planar structure after forming an active layer in a first gate driving circuit according to an exemplary implementation of the present disclosure.
FIG. 20c is a schematic diagram of a planar structure after forming a first conductive layer in a first gate driving circuit according to an exemplary implementation of the present disclosure.
FIG. 20d is a schematic diagram of a planar structure after forming a second conductive layer in a first gate driving circuit according to an exemplary implementation of the present disclosure.
FIG. 20e is a schematic diagram of a planar structure after forming a first via hole layer in a first gate driving circuit according to an exemplary implementation of the present disclosure.
FIG. 20f is a schematic diagram of a planar structure after forming a third conductive layer in a first gate driving circuit according to an exemplary implementation of the present disclosure.
FIG. 20g is a schematic diagram of a planar structure after forming a second via hole layer in a first gate driving circuit according to an exemplary implementation of the present disclosure.
FIG. 20h is a schematic diagram of a planar structure after forming a fourth conductive layer in a first gate driving circuit according to an exemplary implementation of the present disclosure.
FIG. 20i is a schematic diagram of a planar structure of a first gate driving circuit according to an exemplary implementation of the present disclosure.
FIG. 20j is a schematic diagram of a planar structure after forming an active layer in a first gate driving circuit on a shielding structure layer according to an exemplary implementation of the present disclosure.
FIG. 21 is a characteristic curve of a first transistor in a first gate driving circuit according to an exemplary implementation.
FIG. 22a is a characteristic curve of a first transistor in a first gate driving circuit according to an exemplary implementation.
FIG. 22b is a variation curve of a current versus temperature of a first transistor in a first gate driving circuit according to an exemplary implementation.
FIG. 22c is a characteristic curve of a tenth transistor in a first gate driving circuit according to an exemplary implementation.
FIG. 22d is a variation curve of a current versus temperature of a tenth transistor in a first gate driving circuit according to an exemplary implementation.
FIG. 23 is a diagram of a structure of an edge of a display substrate.
FIG. 24 is a diagram of a display effect of a display region.

### Detailed Description

Embodiments of the present disclosure will be described in detail hereinafter with reference to the drawings. Implementation modes may be implemented in a plurality of different forms. Those of ordinary skills in the art can easily understand such a fact that implementation modes and contents may be transformed into various forms without departing from the purpose and scope of the present disclosure. Therefore, the present disclosure should not be explained as being limited to the contents recorded in the following implementations only. The embodiments and features in the embodiments of the present disclosure may be randomly combined with each other if there is no conflict. **In** order to keep following description of the embodiments of the present disclosure clear and concise, detailed description of part of known functions and known components are omitted in the present disclosure. The drawings in the embodiments of the present disclosure relate only to the structures involved in the embodiments of the present disclosure, and other structures may be described with reference to conventional designs.

Scales of the drawings in the present disclosure may be used as a reference in actual processes, but are not limited thereto. For example, a thickness and a pitch of each film layer, and a width and a pitch of each signal line may be adjusted according to an actual situation. The drawings described in the present disclosure are only schematic diagrams of structures, and one implementation of the present disclosure is not limited to shapes or numerical values or the like shown in the drawings.

Ordinal numerals "first", "second", "third", etc., in the specification are set not to form limits in numbers but only to avoid confusion between composition elements.

In the specification, for convenience, expressions "central", "above", "below", "front", "back", "vertical", "horizontal", "top", "bottom", "inside", "outside", etc., indicating directional or positional relationships are used to illustrate positional relationships between the composition elements, not to indicate or imply that involved devices or elements are required to have specific orientations and be structured and operated with the specific orientations but only to easily and simply describe the present specification, and thus should not be understood as limitations on the present disclosure. The positional relationships between the constituent elements may be changed as appropriate according to a direction which is used for describing each constituent element. Therefore, appropriate replacements based on situations are allowed, which is not limited to the expressions in the specification.

In the specification, unless otherwise specified and defined, terms "mounting", "mutual connection", and "connection" should be understood in a broad sense. For example, a connection may be fixed connection, or a detachable connection, or an integral connection; it may be a mechanical connection or an electrical connection; it may be a direct connection, or an indirect connection through middleware, or internal communication inside two elements. Those of ordinary skills in the art may understand specific meanings of the above terms in the present disclosure according to specific situations.

In the specification, a transistor refers to an element that at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. It is to be noted that in the specification, the channel region refers to a region through which a current mainly flows.

In the specification, a first electrode may be a drain electrode, and a second electrode may be a source electrode. Or, the first electrode may be a source electrode, and the second electrode may be a drain electrode. In a case that transistors with opposite polarities are used, or in a case that a direction of a current changes during operation of a circuit, or the like, functions of the "source electrode" and the "drain electrode" are sometimes interchangeable. Therefore, the "source electrode" and the "drain electrode", as well as the "source terminal" and the "drain terminal", are interchangeable in the specification. In an embodiment of the present disclosure, the gate electrode may be referred to as a control electrode.

In the specification, "electrical connection" includes connection of composition elements through an element with a certain electrical action. An "element with a certain electrical action" is not particularly limited as long as electrical signals between the connected constituent elements may be sent and received. Examples of the "element with the certain electrical action" not only include an electrode and a wiring, but also include a switching element such as a transistor, a resistor, an inductor, a capacitor, another element with various functions, etc.

In the specification, "parallel" refers to a state in which an angle formed by two straight lines is -10° or more and 10° or less, and thus also includes a state in which the angle is -5° or more and 5° or less. In addition, "perpendicular" refers to a state in which an angle formed by two straight lines is 80° or more and 100° or less, and thus also includes a state in which the angle is 85° or more and 95° or less.

In the specification, a "film" and a "layer" are interchangeable. For example, a "conductive layer" may be replaced with a "conductive thin film" sometimes. Similarly, an "insulation film" may be replaced with an "insulation layer" sometimes.

Triangle, rectangle, trapezoid, pentagon, hexagon, etc. in this specification are not strictly defined, and they may be approximate triangle, rectangle, trapezoid, pentagon, hexagon, etc. There may be some small deformations caused by tolerance, and there may be chamfer, arc edge, deformation, etc.

In an embodiment of the present disclosure, "about" refers to a value that is not strictly limited, a value within a range of process and measurement error is allowed.

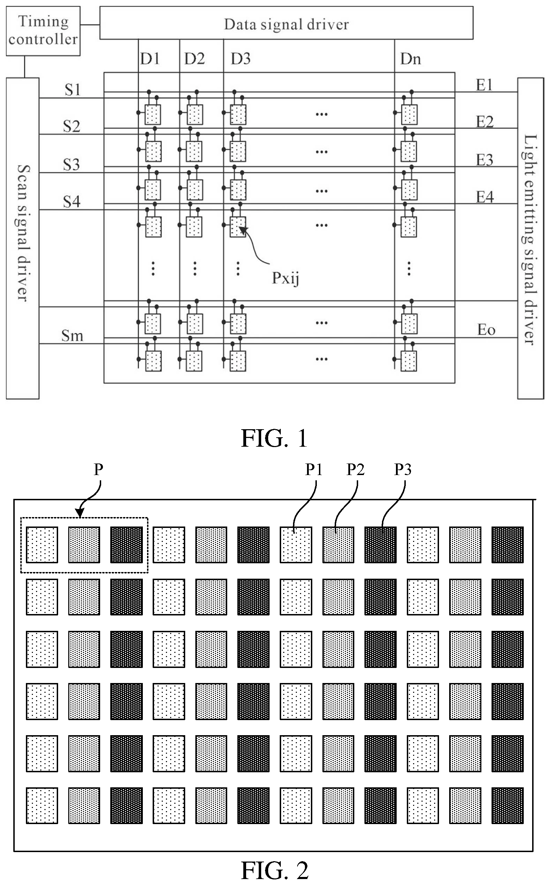

FIG. 1 is a schematic diagram of a structure of a display apparatus, the display substrate may include a timing controller, a data signal driver, a scan signal driver, a light emitting signal driver, and a pixel array. The timing controller is connected with the data signal driver, the scan signal driver, and the light emitting signal driver, respectively, the data signal driver is connected with a plurality of data signal lines (D1 to Dn) respectively, the scan signal driver is connected with a plurality of scan signal lines (S1 to Sm) respectively, and the light emitting signal driver is connected with a plurality of light emitting signal lines (E1 to Eo) respectively. The pixel array may include a plurality of sub-pixels Pxij, wherein i and j may be natural numbers. At least one sub-pixel Pxij may include a circuit unit and a light emitting device connected to the circuit unit, and the circuit unit may include at least one scan signal line, at least one data signal line, at least one light emitting signal line, and a pixel driving circuit. In an exemplary implementation, the timing controller may provide a gray scale value and a control signal suitable for a specification of the data signal driver to the data signal driver, may provide a clock signal, and a scan start signal, etc., suitable for a specification of the scan signal driver to the scan signal driver, and may provide a clock signal, and an emission stop signal, etc., suitable for a specification of the light emitting signal driver to the light emitting signal driver. The data signal driver may generate data voltages to be provided to data signal lines D1, D2, D3, ..., and Dn using the gray scale value and the control signal received from the timing controller. For example, the data signal driver may sample the gray scale value using a clock signal and apply a data voltage corresponding to the gray scale value to the data signal lines D1 to Dn by taking a pixel row as a unit, wherein n may be a natural number. The scan signal driver may generate scan signals to be provided to scan signal lines S1, S2, S3, ..., and Sm by receiving a clock signal, a scan start signal, and the like from the timing controller. For example, the scan signal driver may sequentially provide scan signals with turning-on-level pulses to the scan signal lines S1 to Sm. For example, the scan signal driver may be constructed in a form of a shift register, and generate the scan signals in a mode of sequentially transmitting the scan start signal provided in a form of turning-on-level pulses to a next-stage circuit under controlling of the clock signal, wherein m may be a natural number. The light emitting signal driver may generate an emission signal to be provided to emitting signal lines E1, E2, E3, ..., and Eo by receiving the clock signal, the transmission stop signal, and the like from the timing controller. For example, the light emitting signal driver may sequentially provide an emission signal with an off-level pulse to the light emitting signal lines E1 to Eo. For example, the light emitting driver may be constructed in a form of a shift register and generate an emission signal in a manner of sequentially transmitting an emission stop signal provided in a form of an off-level pulse to a next-stage circuit under control of the clock signal, wherein o may be a natural number.

FIG. 2 is a schematic diagram of a planar structure of a display substrate. As shown in FIG. 2, the display substrate may include a plurality of pixel units P arranged in a matrix, at least one of the plurality of pixel units P includes a first sub-pixel P1 emitting light of a first color, a second sub-pixel P2 emitting light of a second color, and a third sub-pixel P3 emitting light of a third color. The first sub-pixel P1, the second sub-pixel P2, and the third sub-pixel P3 each include a pixel driving circuit and a light emitting device. Pixel driving circuits in the first sub-pixel P1, the second sub-pixel P2, and the third sub-pixel P3 are connected with a scan signal line, a data signal line, and a light emitting signal line respectively. A pixel driving circuit is configured to receive a data voltage transmitted by the data signal line under control of the scan signal line and the light emitting signal line, and output a corresponding current to the light emitting device. Light emitting devices in the first sub-pixel P1, the second sub-pixel P2, and the third sub-pixel P3 are respectively connected with the pixel driving circuit of the sub-pixel in which the light emitting device is located, and the light emitting device is configured to emit light with a corresponding brightness in response to a current outputted by the pixel driving circuit of the sub-pixel in which the light emitting device is located.

In an exemplary implementation, a pixel unit P may include a red (R) sub-pixel, a green (G) sub-pixel, and a blue (B) sub-pixel. In an exemplary implementation, a sub-pixel in the pixel unit may be in a shape of a rectangle, a rhombus, a pentagon, or a hexagon. Three sub-pixels may be arranged side by side horizontally, side by side vertically, or in a manner like a Chinese character " ", which is not limited in the present disclosure.

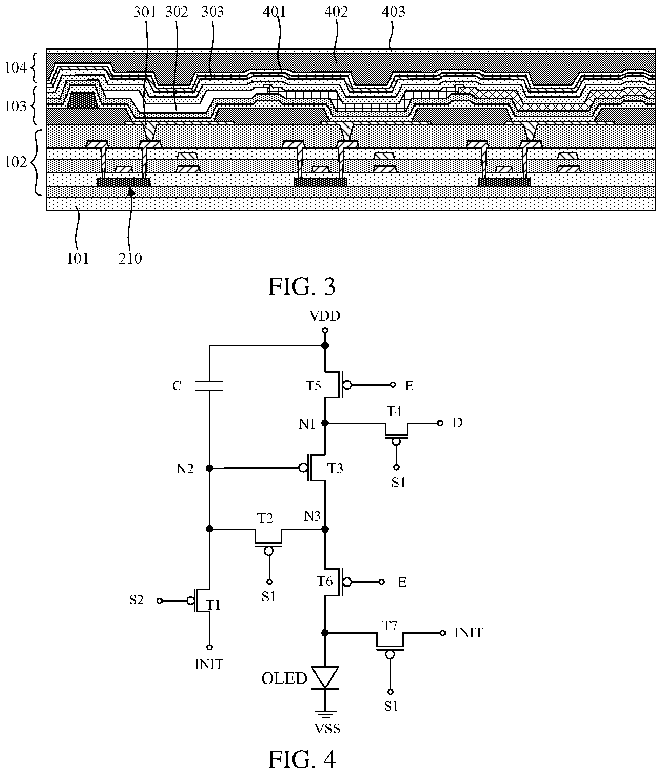

FIG. 3 is a schematic diagram of a cross-sectional structure of a display substrate, which illustrates a structure of three sub-pixels of an OLED display substrate. As shown in FIG. 3, on a plane perpendicular to the display substrate, the display substrate may include a driving circuit layer 102 disposed on a base substrate 101, a light emitting structure layer 103 disposed on a side of the driving circuit layer 102 away from the base substrate 101, and an encapsulation layer 104 disposed on a side of the light emitting structure layer 103 away from the base substrate 101. In some possible implementations, the display substrate may include another film layer, such as a post spacer, which is not limited in the present disclosure.

In an exemplary implementation, the base substrate 101 may be a flexible substrate, or may be a rigid substrate. The driving circuit layer 102 of each sub-pixel may include a plurality of transistors and a storage capacitor constituting a pixel driving circuit. The light emitting structure layer 103 may include an anode 301 connected to a drain electrode of a driving transistor 210 through a via, an organic light emitting layer 302 connected to the anode 301, and a cathode 303 connected to the organic light emitting layer 302, which emits light of corresponding color under drive of the anode 301 and the cathode 303. The encapsulation layer 104 may include a first encapsulation layer 401, a second encapsulation layer 402, and a third encapsulation layer 403 that are stacked. The first encapsulation layer 401 and the third encapsulation layer 403 may be made of an inorganic material, the second encapsulation layer 402 may be made of an organic material, and the second encapsulation layer 402 is disposed between the first encapsulation layer 401 and the third encapsulation layer 403 so as to prevent external water vapor from entering the light-emitting structure layer 103.

In an exemplary implementation, the organic emitting layer 302 may include a Hole Injection Layer (HIL), a Hole Transport Layer (HTL), an Electron Block Layer (EBL), an Emitting Layer (EML), a Hole Block Layer (HBL), an Electron Transport Layer (ETL), and an Electron Injection Layer (EIL) which are stacked. In an exemplary implementation, hole injection layers of all sub-pixels may be connected together to be a common layer, electron injection layers of all the sub-pixels may be connected together to be a common layer, hole transport layers of all the sub-pixels may be connected together to be a common layer, electron transport layers of all the sub-pixels may be connected together to be a common layer, hole block layers of all the sub-pixels may be connected together to be a common layer, emitting layers of adjacent sub-pixels may be overlapped slightly or may be isolated, and electron block layers of adjacent sub-pixels may be overlapped slightly or may be isolated.

In an exemplary implementation, the pixel driving circuit may have a structure of 3T1C, 4T1C, 5T1C, 5T2C, 6T1C, 7T1C, or 8T1C. FIG. 4 is an equivalent circuit diagram of a pixel driving circuit. As shown in FIG. 4, the pixel driving circuit may include seven transistors (a first transistor T1 to a seventh transistor T7) and one storage capacitor C, and the pixel driving circuit may be connected with seven signal lines (a data signal line D, a first scan signal line S1, a second scan signal line S2, a light emitting signal line E, an initial signal line INIT, a first power supply line VDD, and a second power supply line VSS).

In an exemplary implementation, the pixel driving circuit may include a first node N1, a second node N2, and a third node N3. The first node N1 is connected with a first electrode of the third transistor T3, a second electrode of the fourth transistor T4, and a second electrode of the fifth transistor T5 respectively. The second node N2 is connected with a second electrode of the first transistor T1, a first electrode of the second transistor T2, a control electrode of the third transistor T3, and a second terminal of the storage capacitor C respectively. The third node N3 is connected with a second electrode of the second transistor T2, a second electrode of the third transistor T3, and a first electrode of the sixth transistor T6 respectively.

In an exemplary implementation, a first end of the storage capacitor C is connected to the first power supply line VDD, and the second end of the storage capacitor C is connected to the second node N2, i.e., the second end of the storage capacitor C is connected to the control electrode of the third transistor T3.

The control electrode of the first transistor T1 is connected with the second scan signal line S2, the first electrode of the first transistor T1 is connected with the initial signal line INIT, and the second electrode of the first transistor is connected with the second node N2. When a scan signal with an on-level is applied to the second scan signal line S2, the first transistor T1 transmits an initialization voltage to the control electrode of the third transistor T3, so as to initialize a charge amount of the control electrode of the third transistor T3.

A control electrode of the second transistor T2 is connected with the first scan signal line S1, a first electrode of the second transistor T2 is connected with the second node N2, and a second electrode of the second transistor T2 is connected with the third node N3. When a scan signal with an on-level is applied to the first scan signal line S1, the second transistor T2 enables the control electrode of the third transistor T3 to be connected with the second electrode of the third transistor T3.

A control electrode of the third transistor T3 is connected with the second node N2, i.e., the control electrode of the third transistor T3 is connected with the second end of the storage capacitor C, a first electrode of the third transistor T3 is connected with the first node N1, and the second electrode of the third transistor T3 is connected with the third node N3. The third transistor T3 may be referred to as a drive transistor, and the third transistor T3 determines an amount of a drive current flowing between the first power supply line VDD and the second power supply line VSS according to a potential difference between the control electrode and the first electrode of the third transistor T3.

A control electrode of the fourth transistor T4 is connected with the first scan signal line S1, a first electrode of the fourth transistor T4 is connected with the data signal line D, and a second electrode of the fourth transistor T4 is connected with the first node N1. The fourth transistor T4 may be referred to as a switching transistor, a scan transistor, etc., and the fourth transistor T4 enables a data voltage of the data signal line D to be input into the pixel driving circuit when a scan signal with an on-level is applied to the first scan signal line S1.

A control electrode of the fifth transistor T5 is connected with the light emitting signal line E, a first electrode of the fifth transistor T5 is connected with the first power supply line VDD, and a second electrode of the fifth transistor T5 is connected with the first node N1. A control electrode of the sixth transistor T6 is connected to the light emitting signal line E, the first electrode of the sixth transistor T6 is connected to the third node N3, and a second electrode of the sixth transistor T6 is connected to a first electrode of a light emitting device. The fifth transistor T5 and the sixth transistor T6 may be referred to as light emitting transistors. When a light emitting signal with an on-level is applied to the light emitting signal line E, the fifth transistor T5 and the sixth transistor T6 enable the light emitting device to emit light by forming a drive current path between the first power supply line VDD and the second power supply line VSS.

The control electrode of the seventh transistor T7 is connected with the first scan signal line S1, the first electrode of the seventh transistor T7 is connected with the initial signal line INIT, and the second electrode of the seventh transistor T7 is connected with the first electrode of the light emitting device. When a scan signal with an on-level is applied to the first scan signal line S1, the seventh transistor T7 transmits an initialization voltage to the first electrode of the light emitting device so as to initialize a charge amount accumulated in the first electrode of the light emitting device or release a charge amount accumulated in the first electrode of the light emitting device.

In an exemplary implementation, a second electrode of the light emitting device is connected to the second power supply line VSS, a signal of the second power supply line VSS is a low-level signal, and a signal of the first power supply line VDD is a high-level signal continuously provided. The first scan signal line S1 is a scan signal line in a pixel driving circuit in a current display row, and the second scan signal line S2 is a scan signal line in a pixel driving circuit in a previous display row, that is, for the n-th display row, the first scan signal line S1 is S(n), and the second scan signal line S2 is S(n-1). The second scan signal line S2 in the pixel driving circuit in the current display row and the first scan signal line S1 in the pixel driving circuit in the previous display row are the same signal line, such that signal lines of a display panel can be reduced, so as to achieve a narrow bezel of the display panel.

In an exemplary implementation, the first scan signal line S1, the second scan signal line S2, the light emitting signal line E, and the initial signal line INIT extend along a horizontal direction, and the second power supply line VSS, the first power supply line VDD, and the data signal line D extend along a vertical direction.

In an exemplary implementation mode, the light emitting device may be an Organic Light Emitting Diode (OLED) including a first electrode (anode), an organic emitting layer, and a second electrode (cathode) that are stacked.

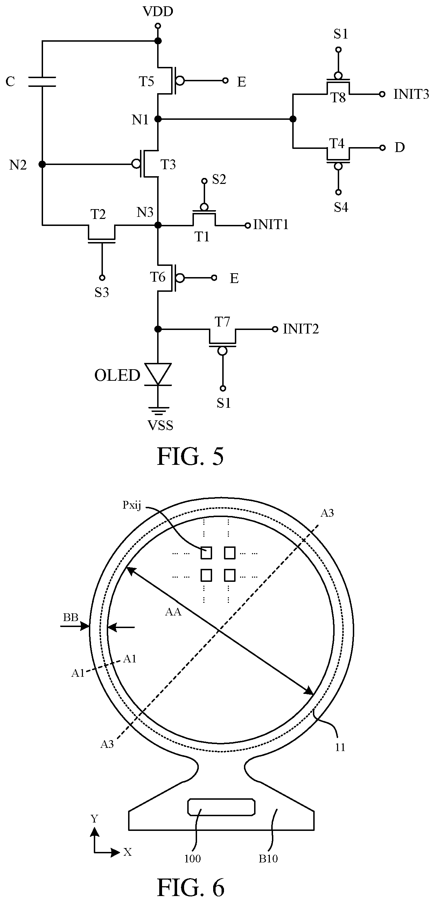

In an exemplary implementation, the first transistor T1 to seventh transistor T7 may be P-type transistors (as shown in FIG. 4) or may be N-type transistors. Use of a same type of transistors in a pixel driving circuit may simplify a process flow, reduce a process difficulty of a display panel, and improve a product yield. In some possible implementations, the first transistor T1 to the seventh transistor T7 may include a P-type transistor and an N-type transistor. FIG. 5 is an equivalent circuit diagram of a pixel driving circuit. In FIG. 5, the second transistor T2 is an N-type transistor (that is, an oxide thin film transistor), and the first transistor T1, the third transistor T3 to the eighth transistor T8 are P-type transistors (that is, low-temperature polysilicon thin film transistors). An active layer of a low temperature poly silicon thin film transistor is made of Low Temperature Poly Silicon (LTPS for short), and an active layer of an oxide thin film transistor is made of an oxide semiconductor (Oxide). A Low temperature poly silicon thin film transistor has advantages such as a high migration rate and fast charging, and an oxide thin film transistor has advantages such as a low leakage current. The low temperature poly silicon thin film transistor and the oxide thin film transistor are integrated on one display substrate to form a Low Temperature Polycrystalline Oxide (LTPO for short) display substrate, so that advantages of both the low temperature poly silicon thin film transistor and the oxide thin film transistor may be utilized, low-frequency drive may be achieved, power consumption may be decreased, and display quality may be improved. As shown in FIG. 5, the pixel driving circuit may include eighth transistors (a first transistor T1 to an eighth transistor T8) and one storage capacitor C, and the pixel driving circuit may be connected with seven signal lines (a data signal line D, a first scan signal line S1, a second scan signal line S2, a light emitting signal line E, an initial signal line INIT, a first power supply line VDD, and a second power supply line VSS). Compared with FIG.4, an eighth transistor T8, a third initial signal line INIT3, a third scan signal line S3, and a fourth scan signal line S4 are added in FIG.5, wherein the third scan signal line S3 is connected to a control electrode of the second transistor T2, and the fourth scan signal line S4 is connected to a control electrode of the fourth transistor T4; the second transistor T2 is an N-type transistor, the first scan signal line S1 is also electrically connected to a control electrode of the eighth transistor T8, a first electrode of the eighth transistor T8 is connected to the third initial signal line INIT3, and a second electrode of the eighth transistor T8 is connected to the first node N; and a first electrode of the first transistor T1 is connected to the first initial signal line INIT1, and a second electrode of the first transistor T1 is electrically connected to the third node N3.

The display panel usually provides a protective film layer (such as the protective layer SCF) on the backlight side (a side of the non-display surface), which may improve the impact resistance of the display panel. The protective film layer SCF is usually composed of a glue layer (which may include Embo glue), a buffer layer (which may include a Foam layer), and a heat dissipation layer (which may include one or more layers of metal copper foil, graphite, etc.), which may play a role of buffering, heat conduction, and shading. The display panel includes a display region and a bezel region, which is located around the display region, and is usually provided with a plurality of gate driving circuits. The gate driving circuit usually adopts a Gate Driver on Array (GOA for short) circuit. Each GOA circuit and transistors in the GOA circuit electrically connected with at least one row of sub-pixels in the display region are greatly affected by light and temperature. When the light or temperature received by a plurality of GOA circuits of the same type are inconsistent, scan signals output from the plurality of GOA circuits of the same type to the display region are often inconsistent. Since an attachment accuracy of the protective film layer SCF is not high, the protective film layer SCF is often misaligned, resulting in a gate driving circuit on a side of the display panel being covered by the protective film layer SCF, and a gate driving circuit on the other side not being covered by the protective film layer SCF; there is a situation where a part of the plurality of gate driving circuits of the same type is covered by the protective film layer SCF, and the other part is not covered by the protective film layer SCF, resulting in the transistor characteristics in the plurality of GOA circuits of the same type are inconsistent, such that the scan signals output from the plurality of GOA circuits covered by the protective film layer SCF and not covered by the protective film layer SCF are inconsistent, which makes brightness of a plurality of sub-pixel rows located in the display region receiving the scan signals output from the gate driving circuit not uniform; in addition, in order to avoid an attachment mark, an edge of the protective film layer SCF is usually provided at a certain distance from an edge of the display panel, and an opening (SCF opening) is usually provided at a position of the attachment mark to avoid shielding the attachment mark; in a case of poor attachment accuracy of the protective film layer SCF, one or more GOA circuits are often not covered by the protective film layer SCF only at the SCF opening position, and GOA circuits of the same type are covered by the protective film layer SCF at other positions, resulting in the scan signals output from the plurality of GOA circuits covered by the protective film layer SCF and not covered by the protective film layer SCF are inconsistent, which makes the brightness of rows of sub-pixels in the display region corresponding to the GOA circuits covered by the protective layer and those not covered by the protective layer not inconsistent, and the brightness of the sub-pixel rows in the display region corresponding to the GOA circuits not covered by the protective film layer SCF are often uniform, such as poor mura (for example, transverse bright strips or dark strips are prone to appear.)

An exemplary embodiment of the present disclosure provides a display module, including a display substrate and a first structure layer, and on a plane parallel to the display substrate, the display substrate includes a display region and a bezel region, the bezel region is located around the display region, wherein the bezel region is provided with first gate driving circuits of at least one type, the number of first gate driving circuits of the same type is a plurality, and the first gate driving circuit includes a plurality of transistors; in a direction perpendicular to a plane of the display substrate, the display substrate includes an light exiting side and a backlight side, wherein the first structure layer is arranged on the backlight side of the display substrate, and an orthographic projection of the first structure layer on the display substrate covers at least a part of the display region, and ranges of at least a part of the transistors in a plurality of first gate driving circuits of the same type covered by an orthographic projection of the first structure layer on the display substrate are consistent.

An embodiment of the present disclosure provides a display module, which includes a display substrate and a first structure layer. The first structure layer is located on a backlight side of the display substrate, and ranges of at least a part of the transistors in a plurality of first gate driving circuits of the same type located in the bezel region of the display substrate covered by an orthographic projection of the first structure layer on the display substrate are consistent, which may overcome a technical problem of uneven brightness of the display module.

In an exemplary implementation, the plane on which the display substrate is located may be a plane or a curved surface.

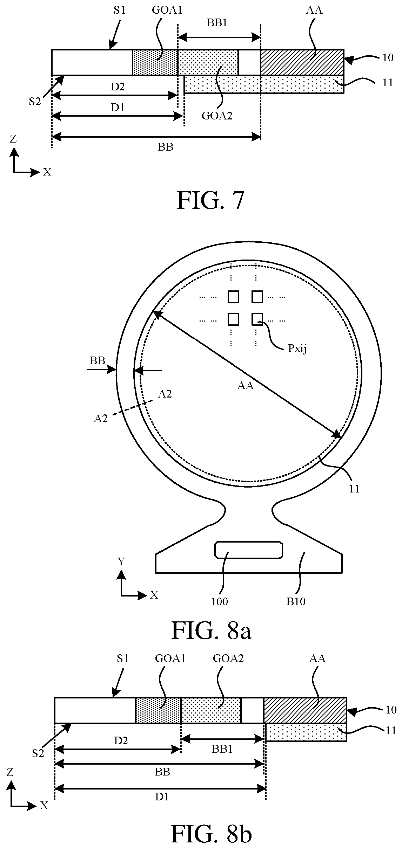

As shown in FIGS. 6 and 7, FIG. 7 is a schematic cross-sectional view of the position A1-A1 in FIG. 6. The display module according to an embodiment of the present disclosure may include a display substrate 10 and a first structure layer 11, and on a plane parallel to the display substrate 10, the display substrate 10 may include a display region AA and a bezel region BB, which is located around the display region AA, and is provided with first gate driving circuits GOA1 of at least one type; the number of the first gate driving circuits GOA1 of the same type is a plurality, and the first gate driving circuit GOA1 includes a plurality of transistors; in a direction Z perpendicular to a plane on which the display substrate is located, the display substrate 10 may include an light exiting side S1 and a backlight side S2, and the first structure layer 11 is provided on a backlight side S2 of the display substrate 10; an orthographic projection of the first structure layer 11 on the display substrate 10 covers at least a part of the display region AA, and ranges of at least a part of transistors in a plurality of first gate driving circuits GOA1 of the same type covered by the orthographic projection of the first structure layer 11 on the display substrate 10 are consistent.

In an exemplary implementation, a plurality of first gate driving circuits GOA1 of the same type may be arranged along an extension direction of the bezel region BB.

In an exemplary implementation, ranges of at least a part of transistors in a plurality of first gate driving circuits GOA1 of the same type covered by the orthographic projection of the first structure layer 11 on the display substrate 10 are consistent, which may be absolute consistent in the ranges, or may be substantially consistent in the ranges, for example, there may be a deviation of about 5% to 15% in the ranges.

In an exemplary implementation, as shown in FIG. 6, the display region AA may include a plurality of rows of sub-pixels Pxij, and the sub-pixel Pxij at least includes a pixel driving circuit, which includes at least one type of an oxide transistor; and the first gate driving circuit GOA1 is electrically connected to a control electrode of the at least one type of the oxide transistor in at least one row of sub-pixels Pxij and is arranged to provide scan signals to the at least one type of the oxide transistor in the at least one row of sub-pixels. In an exemplary implementation, as shown in FIG. 6, each row of sub-pixels may include a plurality of sub-pixels Pxij arranged sequentially along the row direction X, and the display region AA may include a plurality of sub-pixel rows arranged along the column direction Y.

In an exemplary implementation, each pixel driving circuit may include at least one oxide transistor; as shown in FIG. 5, each pixel driving circuit may include one oxide transistor (i.e., a second transistor T2 as a compensation transistor), and the first gate driving circuit may be one type, which is arranged to provide a scan signal to the second transistor T2 in FIG. 5 (a scan signal is provided to a control electrode of the second transistor T2 through the third scan signal line S3); in a case where each pixel driving circuit includes a plurality of oxide transistors, control electrodes of the plurality of oxide transistors in the same pixel driving circuit may provide scan signals through first gate driving circuits of one type (in this case, the type of the first gate driving circuit GOA1 may be arranged to be one type), or control electrodes of a plurality of oxide transistors in the same pixel driving circuit may provide scan signals through first gate driving circuits of a plurality of types (in this case, the type of the first gate driving circuit GOA1 may be arranged to be a plurality of types, and the first gate driving circuits of each type may provide scan signals to the corresponding oxide transistors).

In an exemplary implementation, as shown in FIG. 5, the second transistor T2 in the pixel driving circuit is an oxide transistor, which may control a leakage current of the second node N2 (the leakage current of the second node N2 is avoided as much as possible); since the control electrode of the oxide transistor is greatly affected by a change of the scan signal output from the GOA circuit (the oxide transistor is more sensitive to the change of the scan signal output from the GOA circuit, and the low-temperature polysilicon thin film transistor is relatively insensitive to the change of the scan signal output from the GOA circuit), it is necessary to keep the scan signals output from the GOA circuit that provides the scan signals to oxide transistors in a plurality of rows of sub-pixels as consistent as possible, thereby improving the display uniformity of the display substrate.

In an exemplary implementation, a plurality of transistors in the first gate driving circuit GOA1 at least include a low-level output transistor and a low-level output control transistor, and the low-level output transistor is configured to output low-level signals to the at least one type of the oxide transistor in the at least one row of sub-pixels under the control of the low-level output control transistor;
ranges of the low-level output transistors in a plurality of first gate driving circuits GOA1 of the same type covered by the orthographic projection of the first structure layer 11 on the display substrate are consistent; and ranges of the low-level output control transistors in a plurality of first gate driving circuits GOA1 of the same type covered by the orthographic projection of the first structure layer 11 on the display substrate are consistent.

In the exemplary implementation, ranges of a plurality of first gate driving circuits of the same type covered by the first structure layer 11 are consistent, which may make the plurality of first gate driving circuits GOA1 of the same type are substantially consistent under the influence of factors such as illumination, temperature, and the like, such that scan signals provided by the plurality of first gate driving circuits GOA1 of the same type to a plurality of sub-pixel rows in the display region AA are as consistent as possible, thus the display uniformity of the display substrate may be improved, and the occurrence of transverse bright strips or transverse dark stripes due to the inconsistency of signals output from the plurality of first gate driving circuits GOA1 of the same type may be avoided as much as possible.

In the exemplary implementation, as shown in FIG. 7, a plurality of first gate driver circuits GOA1 of the same type are shielded by the first structure layer 11 in a consistent manner, so that the plurality of first gate driver circuits GOA1 of the same type are shielded by the first structure layer 11 in a consistent manner, which makes signals output from the plurality of first gate driving circuits GOA1 of the same type do not differ too much due to the influence of factors such as temperature, illumination, etc., thus making scan signals provided by the plurality of first gate driving circuits GOA1 of the same type to a plurality of rows of sub-pixels Pxij in the display region AA as consistent as possible, which may overcome the problem that the display region AA has transverse bright stripes or transverse dark stripes to a large extent.

In the exemplary implementation, as shown in FIG. 7, an orthographic projection of the first structure layer 11 on the display substrate 10 is not overlapped with orthographic projections of a plurality of first gate driving circuits GOA1 of at least one type, such that the plurality of first gate driving circuits GOA1 of the same type are kept substantially consistent due to the influence of light and temperature, and the signals output from a plurality of first gate driving circuits GOA1 of the same type are not significantly different due to the influence of light and temperature.

In an exemplary implementation, as shown in FIG. 7, an orthographic projection of an edge of the first structure layer 11 on the display substrate 10 is located in a first region BB1, and on a plane parallel to the display substrate 10, the first region BB1 may be located between edges of a plurality of first gate driving circuits GOA1 of at least one type close to the display region AA and an edge of the display region AA close to the bezel region BB; and an orthographic projection of the first structure layer 11 on the display substrate 10 covers the display region AA.

In an exemplary implementation, as shown in FIGS. 8a and 8b, FIG. 8b is a schematic cross-sectional view of the position A2-A2 in FIG. 8a; an orthographic projection of the first structure layer 11 on the display substrate is not overlapped with the bezel region BB, and the orthographic projection of the first structure layer 11 on the display substrate 10 is within a range of the display region AA or is overlapped with the display region AA, such that the first structure layer 11 does not shield a plurality of first gate driving circuits GOA1 of the same type. For example, an orthographic projection of an edge of the first structure layer 11 on the display substrate may be located close to an edge of the display region AA (for example, the orthographic projection of the edge of the first structure layer 11 on the display substrate may be overlapped with the edge of the display region AA), or the orthographic projection of the first structure layer 11 on the display substrate may be located within a range of the display region AA.

In the exemplary implementation, as shown in FIGS. 7 to 8b, on a plane parallel to the display substrate is located and along a direction of the display region AA to the bezel region BB, a distance D1 between an edge of the first structure layer 11 and an edge of the display substrate is 700 microns to 1200 microns, which is greater than a distance D2 between edges of a plurality of first gate driving circuits GOA1 of at least one type close to the display region AA and an edge of the display substrate (so that the first structure layer 11 does not shield the plurality of first gate driving circuits GOA1 of at least one type), and a distance D2 between edges of the plurality of first gate driving circuits GOA1 of at least one type close to the display region AA and the edge of the display substrate may generally be set from 500 microns to 800 microns. For example, a distance D2 between the edges of the plurality of first gate driving circuits GOA1 of at least one type close to the display region AA and the edge of the display substrate may be 622 microns.

In the exemplary implementation, as shown in FIG. 7, on a plane parallel to the display substrate and in a direction from the display region AA to the bezel region BB on a plane where the display substrate is located, the distance D1 between the edge of the protective structure 110 and the edge of the display substrate may be 700 microns to 1000 microns, for example, the distance D1 between the edge of the first structure layer 11 and the edge of the display substrate 10 may be 872 microns, an attachment accuracy of the first structure layer 11 is ± 230 microns, and an absolute value of the attachment accuracy is less than a difference between D2 and D1 (about 250 microns), so that there will not be a situation that due to the misalignment for attaching the first structure layer 11, a part of the plurality of first gate driving circuits GOA1 of the same type is shielded by the first structure layer 11, and the other part is not shielded by the first structure layer 11.

In the exemplary implementation, as shown in FIG. 8a and FIG. 8b, on a plane parallel to the display substrate and in a direction from the display region AA to the bezel region BB on a plane where the display substrate is located, the distance D1 between the edge of the first structure layer 11 and the edge of the display substrate is 1000 microns to 1200 microns, for example, the distance D1 between the edge of the first structure layer 11 and the edge of the display substrate may be 1150 microns, an attachment accuracy of the first structure layer 11 is ± 250 microns, and an absolute value of the attachment accuracy is less than a difference between D2 and D1 (about 528 microns), so that there will not be a situation that due to the misalignment for attaching the first structure layer 11, a part of the plurality of first gate driving circuits GOA1 of the same type is shielded by the first structure layer 11, and the other part is not shielded by the first structure layer 11.

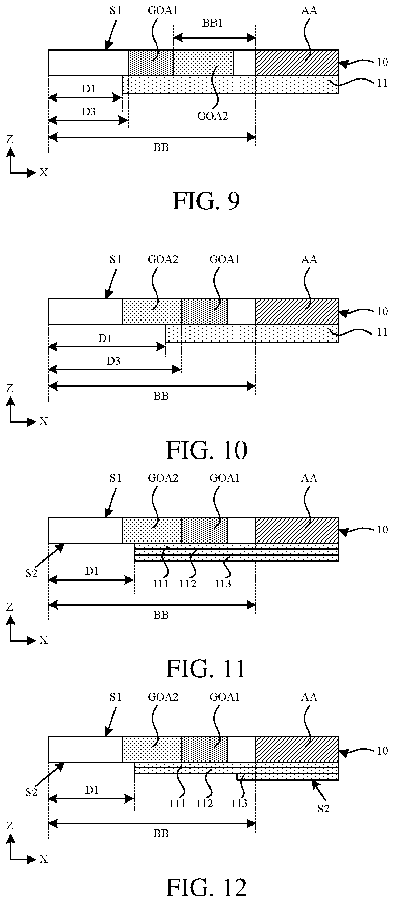

In an exemplary implementation, as shown in FIGS. 9 and 10, in two cross-sectional views of the position A-A1 in FIG. 6, an orthographic projection of the first structure layer 11 on the display substrate covers the display region AA and a plurality of first gate driving circuits of at least one type. That is, a plurality of first gate driving circuits GOA1 of at least one type are located within a range of an orthographic projection of the first structure layer 11 on the display substrate, such that the first structure layer 11 shields all of the plurality of first gate driving circuits GOA1 of at least one type, and signals output from the plurality of first gate driving circuits GOA1 of at least one type are substantially consistent, which may overcome a defect that the signals output from the plurality of first gate driving circuits GOA1 of the same type are inconsistent due to the attachment of the first structure layer 11, and a defect to a large extent that the transverse stripes are generated due to the inconsistency of shielding by the first structure layer 11 to the plurality of first gate driving circuits GOA1.

In the exemplary implementation, as shown in FIG. 9, the bezel region BB is also provided with a plurality of second gate driving circuits GOA2 of at least one type, the number of the second gate driving circuits GOA2 of the same type is a plurality; on a plane parallel to the display substrate, the plurality of second gate driving circuits GOA2 of the same type are arranged along an extension direction of the bezel region BB, and along an direction from the display region AA to the bezel region BB, the plurality of second gate driving circuits GOA2 of at least one type are located between the plurality of first gate driving circuits GOA1 of the at least one type and the display region AA.

In an exemplary implementation, the pixel driving circuit may include at least one Low Temperature Poly-Silicon, and each second gate driving circuit GOA2 is arranged to provide scan signals to at least a part of the Low Temperature Poly-Silicons of at least one row of sub-pixels located in the display region AA. As shown in FIG. 5, the first transistor T1, the third transistor T3 to the eighth transistor T8 are Low Temperature Poly-Silicons, wherein the first transistor T1 may receive scan signals from one of the second gate driving circuits GOA2 of the same type through the second scan signal line S2, the fifth transistor T5 and the sixth transistor T6 may receive light emitting control signals from the second gate driving circuits GOA2 of the same type (may receive light emitting control signals through the light emission signal line E), the seventh transistor T7 and the eighth transistor T8 may receive scan signals from the second gate driving circuits GOA2 of the same type (may receive scan signals through the first scan signal line S1), and the fourth transistor T4 may receive scan signals from one of the second gate driving circuits GOA2 through the fourth scan signal line S4. That is, the types of the second gate driving circuit GOA2 providing signals to the control electrodes of the low temperature polysilicon transistors in the pixel driving circuit shown in FIG. 5 may be four, wherein the second gate driving circuit GOA2 of two types provide scan signals to the control electrodes of the first transistor T1 and the fourth transistor T4, respectively, the second gate driving circuits GOA2 of one type provides light emitting control signals to the fifth transistor T5 and the sixth transistor T6, respectively, and the second gate driving circuits GOA2 of one type provides scan signals to the control electrodes of the seventh transistor T7 and the eighth transistor T8, but embodiments of the present disclosure are not limited thereto, for example, the control electrodes of the fourth transistor T4, the seventh transistor T7, and the eighth transistor T8 may be provided with scan signals by the second gate driving circuits GOA2 of the same type.

In an exemplary implementation, as shown in FIG. 9, on a plane parallel to the display substrate and in a direction from the display region AA to the bezel region BB, a distance D1 between an edge of the first structure layer 11 and an edge of the display substrate 10 may be 100 microns to 350 microns, which is less than a distance D3 between edges of a plurality of first gate driving circuits GOA1 of at least one type away from the display region AA and the edge of the display substrate 10, so that the first structure layer 11 shields all of the plurality of first gate driving circuits GOA1 of at least one type. For example, the distance D1 between the edge of the first structure layer 11 and the edge of the display substrate may be from 100 microns to 250 microns, and the distance D3 between the edges of the plurality of first gate driving circuits GOA1 of at least one type away from the display region AA and the edge of the display substrate 10 may be from 300 microns to 500 microns (for example, D1 may be set to 250 microns, D3 may be set to 482 microns, an attachment accuracy of the first structure layer 11 is ± 230 microns, and an absolute value of the attachment accuracy is less than a difference between D3 and D1, so that there will not be a situation that due to the misalignment for attaching the first structure layer 11, a part of the plurality of first gate driving circuits GOA1 of the same type is shielded by the first structure layer 11, and the other part is not shielded by the first structure layer 11).

In the exemplary implementation, as shown in FIG.10, the bezel region BB is also provided with second gate driving circuits GOA2 of at least one type, the number of the second gate driving circuits GOA2 of the same type is a plurality; on a plane parallel to the display substrate, the plurality of second gate driving circuits GOA2 of the same type are arranged along an extension direction of the bezel region BB, and along an direction from the display region AA to the bezel region BB, the plurality of second gate driving circuits GOA2 of at least one type are located on side of the plurality of first driving circuits GOA1 of the at least one type away from the display region AA.

In an exemplary implementation, as shown in FIG. 10, on a plane parallel to the display substrate and in a direction from the display region AA to the bezel region BB, the distance D1 between an edge of the first structure layer 11 and an edge of the display substrate is 500 microns to 700 microns, which is less than a distance D3 between edges of the first gate driving circuits GOA1 of at least one type away from the display region AA and the edge of the display substrate 10, so that the first structure layer 11 shields all of the plurality of first gate driving circuits GOA1 of at least one type. For example, the distance D1 between the edge of the first structure layer 11 and the edge of the display substrate is 600 microns, and the distance D3 between the edges of the first gate driving circuits GOA1 of at least one type away from the display region AA and the edge of the display substrate 10 is 622 microns.

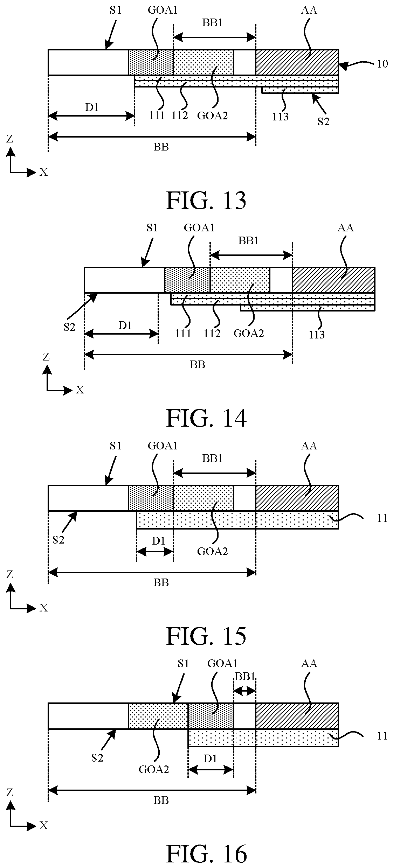

In an exemplary implementation, as shown in FIGS. 11 to 14, which are schematic cross-sectional views of several structures of the position A1-A1 in FIG. 6. The first structure layer 11 may include a first connection structure layer 111, a buffer structure layer 112, and a heat dissipation structure layer 113 sequentially arranged on the backlight side S2, and as shown in FIGS. 12 and 13, an orthographic projection of the heat dissipation structure layer 113 on the display substrate 10 is overlapped with a plurality of first gate driving circuits GOA1 of at least one type. A material of the heat dissipation structure layer 113 may be metal (such as copper), and the heat dissipation structure layer 113 may play a heat dissipation role (in favor of reducing the temperature of the display substrate 10). In FIGS. 12 to 13, the heat dissipation structure layer 113 does not shield a plurality of first gates driving circuits GOA1 of at least one type, so that the influence of the heat dissipation structure layer 113 on the plurality of first gate driving circuits GOA1 of at least one type can be consistent, and a situation that signals output from the plurality of first gate driving circuits GOA1 of the same type are inconsistent may be avoided due to the inconsistency of the coverage of the heat dissipation structure layer 113. In an exemplary implementation, as shown in FIG. 12, an orthographic projection of an edge of the heat dissipation structure layer 113 on the display substrate may be located between an edge of the display region AA close to the bezel region BB and edges of the first gate driving circuits GOA1 of at least one type close to the display region AA, i.e., the orthographic projection of the edge of the heat dissipation structure layer 113 on the display substrate 10 may cover the display region AA, and the orthographic projection of the edge of the heat dissipation structure layer 113 on the display substrate 10 is not overlapped with the first gate driving circuits GOA1 of at least one type; or as shown in FIG. 13, the orthographic projection of the heat dissipation structure layer 113 on the display substrate 10 may be located within a range of the display region AA; and as shown in FIG. 14, the orthographic projection of the edge of the heat dissipation structure layer 113 on the display substrate may be within a range of the plurality of second gate driving circuits GOA2 of at least one type, that is, the orthographic projection of the edge of the heat dissipation structure layer 113 on the display substrate 10 may cover the display region AA and at least a part of the second gate driving circuits GOA2, and the orthographic projection of the edge of the heat dissipation structure layer 113 on the display substrate 10 is not overlapped with the first gate driving circuit of at least one type.

In an exemplary implementation, as shown in FIG. 11, the orthographic projection of the heat dissipation structure layer 113 on the display substrate 10 may cover a plurality of first gate driving circuits GOA1 of at least one type, that is, the heat dissipation structure layer 113 may shield all of the plurality of first gate driving circuits GOA1 of the same type, so that the influence of the heat dissipation structure layer 113 on the plurality of first gate driving circuits GOA1 of the same type is consistent, and the signals output from the plurality of first gate region circuits GOA1 of the same type are not consistent due to the inconsistent shielding of the plurality of first gate driving circuits GOA1 of the same type by the heat dissipation structure layer 113 are avoided, thereby avoiding a defect that the brightness of the display region AA is not uniform.

In an exemplary implementation, as shown in FIGS. 11 to 12, orthographic projections of the first connection structure layer 111 and the buffer structure layer 112 on the display substrate 10 may cover a plurality of first gate driving circuits GOA1 of at least one type, such that the influence of the first connection structure layer 111 and the buffer structure layer 112 on the plurality of first gate driving circuits GOA1 of the same type are consistent. As shown in FIGS. 13 and 14, the coverage of the plurality of first gate driving circuits GOA1 of at least one type covered by orthographic projections of the first connection structure layer 111 and the buffer structure layer 112 on the display substrate 10 are consistent.

In an exemplary implementation, as shown in FIGS. 11 to 14, the first structure layer 11 may serve as a protective film layer (SCF), the first connection structure layer 111 may be a glue layer (including Embo glue) in the protective film layer (SCF), the buffer structure layer 112 may be a buffer layer (including Foam layer) in the protective film layer (SCF), and the heat dissipation structure layer 113 may be a heat dissipation layer (including one or more layers of metal copper foil, graphite, etc.) in the protective film layer (SCF); and in a direction perpendicular to a plane on which the display substrate 10 is located, a dimension (i.e., thickness) of the first connection structure layer 111 may be 0.01 microns to 0.05 microns (e.g., may be 0.03 microns), a dimension (i.e., thickness) of the buffer structure layer 112 may be 0.05 microns to 0.11 microns (e.g., may be 0.08 microns), and a dimension (i.e., thickness) of the heat dissipation structure layer 113 may be 0.03 microns to 0.07 microns (e.g., may be 0.05 microns).

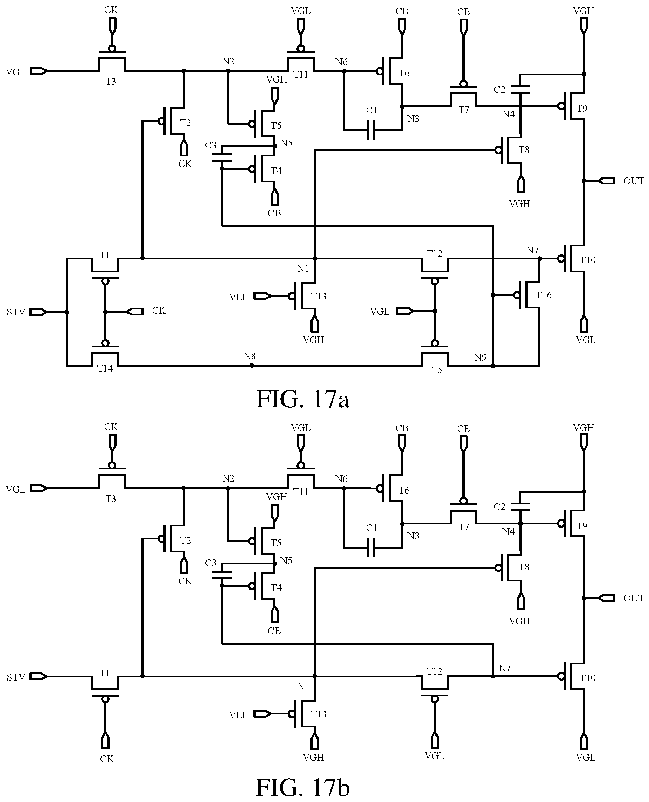

In an exemplary implementation, as shown in FIGS. 15 to 17a, FIGS. 15 and 16 are schematic diagrams of two sectional structures at positions A1-A1 in FIG. 1, and FIG. 17a is an equivalent circuit schematic diagram of a first gate driving circuit GOA1; the first gate driving circuit GOA1 may include a plurality of transistors, an orthographic projection of the first structure layer 11 on the display substrate 10 may cover at least a part of the transistors in the plurality of first gate driving circuits GOA1 of the same type, and at least a part of the transistors in the different first driving circuits GOA1 of the same type (e.g., low-level output transistors and low-level output control transistors) are covered in a manner consistent with orthographic projections of the first structure layer 11 on the display substrate, such that at least a part of the transistors in the plurality of first gate driving circuits GOA1 of the same type (e.g., low-level output transistors and low-level output control transistors) will not make the scan signals output from the plurality of first gate driving circuits GOA1 of the same type inconsistent due to a range of shielding the first structure layer 11.

In an exemplary implementation, the orthographic projection of the first structure layer 11 on the display substrate at least covers at least one of low-level output transistors and low-level output control transistors in a plurality of first gate driving circuits GOA1 of at least one type. For example, an orthographic projection of the first structure layer 11 on the display substrate covers low-level output transistors in the plurality of first gate driving circuits GOA1 of at least one type, such that the low-level output transistors in the plurality of first gate driving circuits of at least one type are all shielded by the first structure layer 11 (none of the low-level output control transistors in the plurality of first gate driving circuits GOA1 of at least one type are shielded by the first structure layer 11); or, the orthographic projection of the first structure layer 11 on the display substrate covers low-level output control transistors in the plurality of first gate driving circuits GOA1 of at least one type, such that the low-level output control transistors in the plurality of first gate driving circuits GOA1 of at least one type are all shielded by the first structure layer 11 (none of the low-level output transistors in the plurality of first gate driving circuits GOA1 of at least one type are shielded by the first structure layer 11); or the orthographic projection of the first structure layer 11 on the display substrate covers low-level output transistor and low-level output control transistor in the plurality of first gate driving circuits GOA1 of at least one type, such that the low-level output transistor and the low-level output control transistor in the plurality of first gate driving circuits GOA1 of at least one type are shielded by the first structure layer 11.

In an exemplary implementation, as shown in FIGS. 17a to 17e, which are equivalent circuit schematics of several first gate driving circuits GOA1. A plurality of transistors may include a first transistor T1 (which may serve as the low-level output control transistor described above) and a tenth transistor T10 (which may serve as the low-level output transistor described above), and an orthographic projection of the first structure layer 11 on the display substrate covers at least one of the first transistor T1 and the tenth transistor T10 of the plurality of first gate driving circuits GOA1 of at least one type. For example, an orthographic projection of the first structure layer 11 on the display substrate 10 covers the first transistors T1 in the plurality of first gate driving circuits GOA1 of at least one type, such that the first transistors T1 in the plurality of first gate driving circuits GOA1 of at least one type are all shielded by the first structure layer 11 (none of the tenth transistors T10 in the plurality of first gate driving circuits GOA1 of at least one type are shielded by the first structure layer 11); or the orthographic projection of the first structure layer 11 on the display substrate covers the tenth transistors T10 in the plurality of first gate driving circuits GOA1 of at least one type, such that the tenth transistors T10 in the plurality of first gate driving circuits GOA1 of at least one type are all shielded by the first structure layer 11 (none of the first transistors T1 in the plurality of first gate driving circuits GOA1 of at least one type are shielded by the first structure layer 11); or the orthographic projection of the first structure layer 11 on the display substrate covers the first transistors T1 and the tenth transistors T10 in the plurality of first gate driving circuits GOA1 of at least one type, such that the first transistors T1 and the tenth transistors T10 in the plurality of first gate driving circuits GOA1 of at least one type are shielded by the first structure layer 11.

In an exemplary implementation, as shown in FIGS. 17a to 17e, the first gate driving circuit GOA1 includes a plurality of transistors, the low-level output control transistor (the first transistor T1 in FIGS. 17a to 17e) and the low-level output transistor (the tenth transistor T10 in FIGS. 17a to 17e) have a greater influence on the signals output from the output terminal OUT of the first gate driving circuit GOA1. The low-level output control transistor and the low-level output transistor in the plurality of first gate driving circuits GOA1 of the same type are not consistent in the shielding range by the first structure layer 11, and the display region AA may produce obvious transverse stripes or uneven brightness and darkness during operation. Therefore, the first structure layer 11 is arranged to be consistent with the shielding range of the low-level output control transistors and the low-level output transistors in the plurality of first gate driving circuits GOA1 of the same type, which may overcome a defect to a large extent that the display region AA has transverse stripes or uneven brightness and darkness during operation.

In FIGS. 17a and 17b, the control electrode of the thirteenth transistor T13 is electrically connected to a power supply VEH, which is at a low level in the starting state, and stabilize a floating state before the output terminal OUT of the first gate driving circuit GOA1 is set high to a high level, which may make a signal of the output terminal OUT more stable, and prevent the splash screen of the first frame screen; and the fourteenth transistors T14 to sixteenth transistors T16 in FIG. 17a may reduce a disturbance of the output terminal OUT, eliminate a waveform step signal output from the output terminal OUT, and improve a stability of the output signal. In an embodiment of the present disclosure, the shielding ranges of the first transistor T1 and the tenth transistor T10 in the plurality of first gate driving circuits GOA1 are consistent, so that the signals output from the output terminal OUT of the plurality of first gate driving circuits GOA1 are consistent, thereby improving the display uniformity and preventing a defect that there are transverse strips in the display region AA. In FIGS. 17a to 17e, the first transistor T1 mainly controls a potential of the seventh node N7 (that is, controls a potential of a control electrode of the tenth transistor T10), and the tenth transistor T10 mainly outputs a signal of the low level VGL on a control line of the seventh node N7.

In the exemplary implementation, as shown in FIGS. 17a to 17e, a control electrode of the first transistor T1 (the low-level output control transistor) may be electrically connected to a clock signal terminal CK, a first electrode of the first transistor T1 may be electrically connected to a input signal terminal STV, and a second electrode of the first transistor T1 may be electrically connected to a first node N1 (a control electrode of the twelfth transistor T2 is electrically connected to a low-level signal terminal VGL and is in a normally open state, so that a potential of the seventh node N7 is substantially consistent with a potential of the first node N1, so that the first transistor T1 may control a potential of the seventh node N7); and a control electrode of the tenth transistor T10 (the low-level output transistor) may be electrically connected to a seventh node N7, a first electrode of the tenth transistor T10 may be electrically connected to a low-level signal terminal VGL, and a second electrode of the tenth transistor T10 may be electrically connected to the output terminal OUT, and a signal of the low-level signal terminal VGL may be transmitted to the output terminal OUT under the control of the seventh node N7.

In an exemplary implementation, as shown in FIGS. 15 to 16, on a plane parallel to the display substrate and along a direction from the display region AA to the bezel region BB, the low-level output control transistor is located on a side of the low-level output transistor away from the display region AA, a length dimension of the first gate driving circuits GOA1 of at least one type is 120 microns to 150 microns, the low-level output control transistor and the low-level output transistor are located on both sides of a centerline of the first gate driving circuit GOA1 along an extension direction of the bezel region BB, and a distance between the low-level output control transistor and the low-level output transistor may be 40 microns to 50 microns;

In a structure in which an orthographic projection of the first structure layer 11 on the display substrate 10 covers low-level output transistor and a low-level output control transistor in a plurality of first gate driving circuits GOA1 of at least one type, along a direction of the display region AA to the bezel region BB, a length dimension of at least one type of first gate driving circuit GOA1 of at least one type covered by the orthographic projection of the first structure layer 11 on the display substrate 10 is 100 microns to 150 microns , and a length dimension of the first gate driving circuit GOA1 covered by the orthographic projection of the first structure layer 11 on the display substrate may be 70% to 100% of a length dimension of the first gate driving circuit GOA1, such that the first structure layer 11 may shield both the low-level output transistor and the low-level output control transistor. For example, along a direction from the display region AA to the bezel region BB, a length dimension of the first gate driving circuits GOA1 of at least one type may be 138 microns, and a length dimension of the first gate driving circuit GOA1 covered by the orthographic projection of the first structure layer 11 on the display substrate 10 is 100 microns;

In a structure in which the orthographic projection of the first structure layer 11 on the display substrate covers low-level output transistors in a plurality of first gate driving circuits of at least one type, along a direction of the display region AA to the bezel region BB, a length dimension of the orthographic projection of the first structure layer 11 on the display substrate covers first gate driving circuit GOA1 of at least one type is 40 microns to 95 microns; and for example, along a direction from the display region AA to the bezel region BB, a length dimension of the first gate driving circuit GOA1 of at least one type may be 138 microns, and a length dimension of the first gate driving circuit GOA1 covered by the orthographic projection of the first structure layer 11 on the display substrate 10 is 50 microns, so that the first structure layer 11 shields the low-level output transistors in the plurality of first gate driving circuits GOA1 of at least one type, and does not shield the low-level output control transistors in the plurality of first gate driving circuits GOA1 of at least one type.

In an exemplary implementation, as shown in FIGS. 15 and 16, the bezel region BB may also be provided with a plurality of second gate driving circuits GOA2 of at least one type, and on a plane parallel to the display substrate, the plurality of second gate driving circuits GOA2 of the same type are arranged along an extension direction of the bezel region BB;

In a direction of the display region AA to the bezel region BB, the plurality of second driving circuits GOA2 of at least one type may be located on a side of the plurality of first driving circuits GOA1 of at least one type away from the display region AA (as shown in FIG. 16), or the plurality of second gate driving circuits GOA2 of at least one type may be located between the plurality of first gate driving circuits GOA1 of at least one type and the display region AA (as shown in FIG. 15).

In an exemplary implementation, on a plane parallel to the display substrate, the first gate driving circuits GOA1 of different types may be arranged along a direction of the display region AA to the bezel region BB, the second gate driving circuits GOA2 of different types may be arranged along the direction of the display region AA to the bezel region BB, and the first gate driving circuit GOA1 and the second gate driving circuit GOA2 may be arranged in the direction of the display region AA to the bezel region BB .

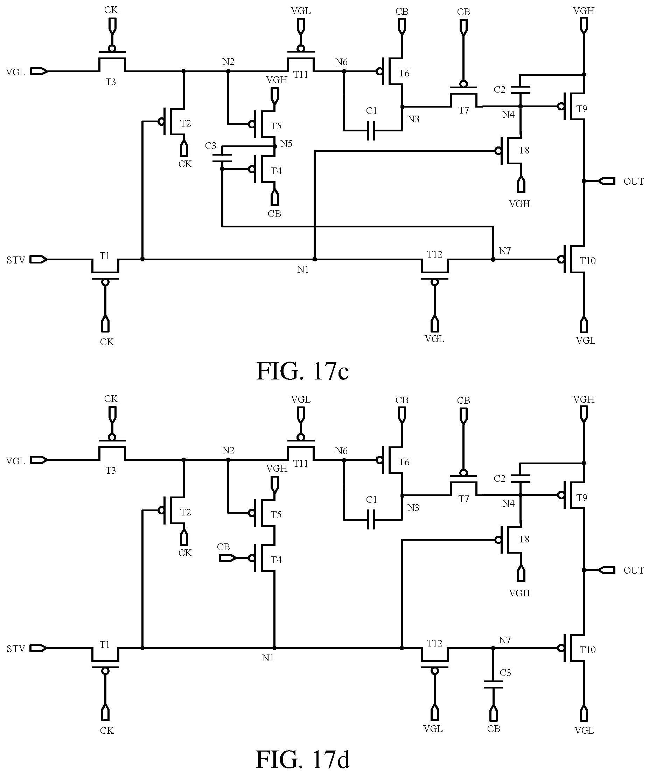

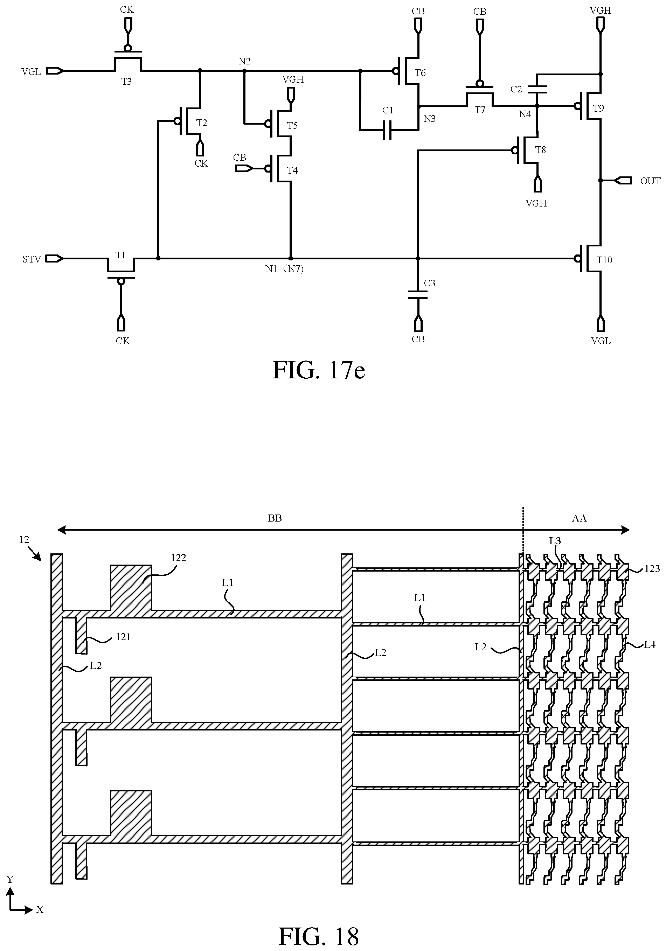

In an exemplary implementation, as shown in FIG. 18, the display substrate 10 may also include a shielding structure layer 12; in a direction Z perpendicular to a plane on which the display substrate is located, the shielding structure layer 12 is located on a side of the first gate driving circuit GOA1 away from the light exiting side S1, and the shielding structure layer 12 may at least include at least one of the first shielding structure 121 and the second shielding structure 122;
the number of the first shielding structures 121 is a plurality, and the plurality of the first shielding structures 121 are respectively configured to shield the low-level output control transistors in the plurality of the first gate driving circuits GOA1 of at least one type (the first transistor T1 in FIG. 17 may serve as the low-level output control transistor); and the number of second shielding structures 122 is plurality, and the plurality of second shielding structures 122 are respectively configured to shield low-level output transistors in a plurality of first gate driving circuits GOA1 of at least one type (the tenth transistor T10 in FIG. 17 may serve as low-level output control transistors). The low-level output control transistors in different first gate driving circuits GOA1 of the same type are shielded by the first shielding structure 121 in a consistent manner, so that characteristics of the low-level output control transistors in the plurality of first gate driving circuits GOA1 are kept as consistent as possible to prevent the display region AA from having transverse stripes due to the inconsistency of characteristics of the low-level output control transistors in the plurality of first gate driving circuits; and the low-level output transistors in the different first gate driving circuits GOA1 of the same type are shielded by the second shielding structure 122 in a consistent manner, so that characteristics of the low-level output transistors in the plurality of first gate driving circuits GOA1 are kept as consistent as possible to prevent the display region AA from having transverse stripes due to the inconsistency of the characteristics of the low-level output transistors in the plurality of first gate driving circuits GOA1.

In an exemplary implementation, the display substrate may also include a substrate, and in a direction Z perpendicular to a plane on which the display substrate is located, the shielding structure layer 12 may be located between the base substrate and the first gate driving circuit GOA1, wherein an orthographic projection of the first shielding structure 121 on the base substrate covers an orthographic projection of the corresponding low-level output control transistors on the base substrate, and an orthographic projection of the second shielding structure 122 on the base substrate covers an orthographic projection of the corresponding low-level output transistors on the base substrate.

In an exemplary implementation, as shown in FIG. 18, the shielding structure layer 12 may also include a third shielding structure 123, whose orthographic projection on the base substrate covers the third transistor T3 (the third transistor T3 shown in FIG. 5) in the pixel driving circuit, wherein on a plane parallel to the display substrate, the first shielding structure 121 and the second shielding structure 122 are located in the bezel region BB, and the third shielding structure 123 is located in the display region AA. In an embodiment of the present disclosure, the shielding structure located in the bezel region BB may be formed with the shielding structure located in the display region AA through a same process, and without increasing the process flow, providing a shielding structure in the bezel region BB may solve a defect that the brightness of the display region is not uniform due to the inconsistency of transistor characteristics in the first gate driving circuit GOA1.

In an exemplary implementation, as shown in FIG. 18, the shielding structure layer 12 may further include a plurality of first connection structures L1, a plurality of second connection structures L2, a plurality of third connection structures L3, and a plurality of fourth connection structures L4, wherein the plurality of first connection structures L1 and the plurality of third connection structures L3 extend along the first direction X and are arranged along the second direction Y, and the plurality of second connection structures L2 and the plurality of fourth connection structures L4 are arranged along the first direction X and extend along the second direction Y; at least a part of the first connection structure L1 is arranged to connect two adjacent second connection structures L2, the first connection structure 121 and the second connection structure 122 to be of an integral structure, at least a part of the first connection structure L1 is arranged to connect two adjacent second connection structures L2 to be of an integral structure, at least a part of the third connection structure L3 is arranged to connect two adjacent third shielding structures 123 to be of an integral structure, and at least a part of the third connection structure L3 is arranged to connect the third shielding structure 123 at a position of the display region AA close to the bezel region BB and the second connection structure L2 in the bezel region close to the display region AA to be of an integral structure; and the first shielding structure 121, the second shielding structure 122, and the third shielding structure 123 are connected to each other through the first connection structure L1 to the fourth connection structure L4 to form an integral structure.

In an exemplary implementation, the first shielding structure layer 12 may be electrically connected to the first power supply VDD, such that the third transistor T3 in the pixel driving circuit is negatively biased (i.e., the third transistor T3 threshold voltage is negatively biased), or the first shielding structure layer 12 may be electrically connected to the second power supply VSS, such that the third transistor T3 in the pixel driving circuit is positively biased (i.e., the third transistor T3 threshold voltage is positively biased).

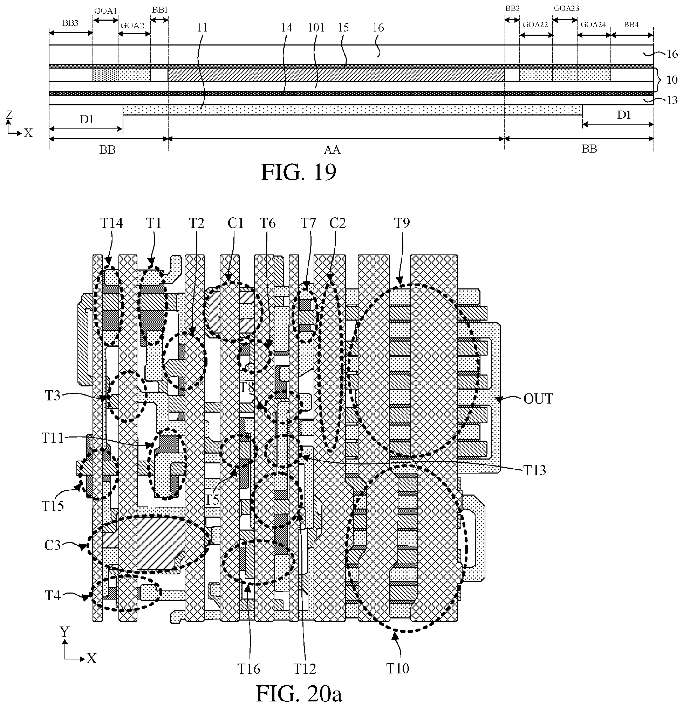

In an exemplary implementation, as shown in FIG. 19, it is a schematic diagram of a cross-sectional structure of the positions A3-A3 in FIG. 6. As shown in FIG. 3, in a direction Z perpendicular to a plane on which the display substrate 10 is located, the display substrate 10 may include a substrate 101, a driving circuit layer 102 (which may include a pixel driving circuit located in the display region AA, a first gate driving circuit GOA1 and a second gate driving circuit GOA2 located in the bezel region), a light emitting structure layer 103, and a encapsulation layer 104; as shown in FIG. 19, in a direction Z perpendicular to a plane where the display substrate 10 is located, the display module may include a first structure layer 11, a second structure layer 13 (which may be a back film layer of the display module), a second connection structure layer 14, a display substrate 10, a third connection structure layer 15, and a third structure layer 16 which are arranged sequentially, wherein the first structure layer 11 may be arranged on a side of the second structure layer 13 away from the display substrate 10 through the first connection structure layer 111, the second structure layer 13 may be arranged on a backlight side of the display substrate 10 through the second connection structure layer 14, the third structure layer 16 may be arranged on a light exiting side of the display substrate 10 through the third connection structure layer 15 (which may be an optical glue layer), the second structure layer 13 may be a backplane layer of the display module, and the third structure layer 16 may be a cover plate layer of the display module, and the cover plate layer may be a transparent structure or a light transmitting structure.

In an exemplary implementation, as shown in FIG. 19, on a plane parallel to the display base 10, the circular display region AA may have a diameter dimension of 20 to 40 millimeters (e.g., may be 32.1912 millimeters), the circular first structure layer 11 may have a diameter dimension of 20 to 40 millimeters (e.g., may be 33.29 millimeters), the circular display substrate 10 may have a diameter dimension of 25 to 45 millimeters (e.g., may be 34.4912 millimeters), and along the direction of the display region AA to the bezel region BB, a distance D1 from the first structure layer 11 to an edge of the display substrate 10 may be 500 microns to 700 microns (e.g., D1 may be 600 microns).

In an exemplary implementation, as shown in FIGS. 6 and 19, a plurality of gate driving circuits GOA may be provided on both sides of a centerline of the display substrate 10 extending along the second direction Y, wherein a first gate driving circuit GOA1 and second gate driving circuits GOA2 of at least one type (such as GOA21) are provided on a side of the centerline, and a first region BB1 is provided between an edge of the display region AA and an edge of the gate driving circuit GOA close to the display region AA; a third region BB3 is provided between edges of the gate driving circuits GOA away from the display region AA and an edge of the display substrate 10, and all gate driving circuits GOA located in the bezel region BB may have a dimension of 0.2 mm to 0.4 mm (e.g., may be 0.328 mm); and the second gate driving circuits GOA2 of at least one type (e.g., GOA22, GOA23, GOA24) are provided on the other side, and a second region BB2 is provided between an edge of the display region AA and edges of the gate driving circuits GOA close to the display region AA, and a fourth region BB4 is provided between edges of the gate driving circuit GOA away from the display region AA and the edge of the display substrate 10, and dimensions of all gate driving circuits GOA located in the bezel region BB may be 0.2 millimeters to 0.4 millimeters (e.g., may be 0.372 millimeters). In a plane parallel to the display base 10 is located, and along a direction from the display region AA to the bezel region BB, the first region BB1 may have a dimension of 0.2 mm to 0.5 mm (e.g., may be 0.34 mm), the second region BB2 may have a dimension of 0.1 mm to 0.4 mm (e.g., may be 0.296 mm), the third region BB3 and the fourth region BB4 may have a dimension of 0.3 mm to 0.6 mm (e.g., may be 0.482 mm), the first gate driving circuit GOA1 may have a dimension of 0.1 mm to 0.3 mm (e.g., may be 0.14 mm), the second gate driving circuit GOA21 may have a dimension of 0.1 mm to 0.3 mm (e.g., may be 0.188 mm), the second gate driving circuit GOA22 may have a dimension of 0.1 mm to 0.3 mm (e.g., may be 0.138 mm), the second gate driving circuit GOA23 may have a dimension of 0.05 mm to 0.2 mm (e.g., may have a dimension of 0.094 mm), and the second gate driving circuit GOA24 may have a dimension of 0.1 mm to 0.3 mm (e.g., may have a dimension of 0.14 mm).

In an exemplary implementation, as shown in FIGS. 5 and 19, the first gate driving circuit GOA1 provides a scan signal to the second transistor T2 in FIG. 5 through the third scan signal line S3; the second gate driving circuit GOA21 may provide a scan signal to the fourth transistor T4 in FIG. 5 through the fourth scan signal line S4; the second gate driving circuit GOA22 may provide a scan signal to the first transistor T1 in FIG. 5 through the second scan signal line S2; the second gate driving circuit GOA23 may provide light emitting control signals to the fifth transistors T5 and the sixth transistors T6 in FIG. 5 through the light emitting signal line E; and the second gate driving circuit GOA24 may provide scan signals to the seventh transistors T7 and the eighth transistors T8 in FIG. 5 through the first scan signal line S1.

In an exemplary implementation, as shown in FIGS. 6 and 8a, the bezel region BB on a side of the display region AA may be provided with a bonding region B10, which may be provided with a driver chip 100 (driver IC), and is configured to provide data signals to a plurality of sub-pixels of the display substrate 10.

In an exemplary implementation, as shown in FIG. 17a, the first gate driving circuit GOA1 may include a plurality of transistors, the plurality of transistors may include a first transistor T1 to a sixteenth transistor T16, and the plurality of capacitors may include a first capacitor C1 to a third capacitor C3. FIGS. 20a to 20j are schematic diagrams of a structure of the first gate driving circuit GOA1 shown in FIG. 17a. The structure of the first gate driving circuit GOA1 is described in detail below with reference to FIGS. 20a to 20j.

As shown in FIG. 20a, which is a planar schematic diagram of the first gate driving circuit GOA1, on a plane parallel to the display substrate, in the first direction X, the first transistor T1 and the ninth transistor T9 are located on both sides of the first capacitor C1, the fourteenth transistor T14 is located on a side of the first transistor T1 away from the ninth transistor T9, the second capacitor C2 is located between the first capacitor C1 and the ninth transistor T9, the seventh transistor T7 is located between the first capacitor C1 and the second capacitor C2, the second transistor T2, the third transistor T3, the fifth transistor T5 to the eighth transistor T8, the eleventh transistor T11, and the thirteenth transistor T13 are located on a side of the second capacitor C2 away from the ninth transistor T9, the fifteenth transistor T15 and the tenth transistor T10 are located on both sides of the eleventh transistor T11, the twelfth transistor T12 and the sixteenth transistor T16 are located between the eleventh transistor T11 and the tenth transistor T10, and the third capacitor C3 and the fourth transistor T4 are located on a side of the sixteenth transistor T16 away from the tenth transistor T10; in the second direction Y, the ninth transistors T9 and the tenth transistors T10 are arranged along an opposite direction of the second direction Y, the seventh transistors T7, the sixth transistors T6, the eighth transistors T8, the fifth transistors T5 and the twelfth transistors T12, and the sixteenth transistors T16 are arranged sequentially along an opposite direction of the second direction Y, and the first transistors T1, the fourteenth transistors T14, the third transistor T3, the fifteenth transistors T15 and the eleventh transistors T11, the third capacitor C3, and the fourth transistor T4 are arranged sequentially along the opposite direction of the second direction Y.

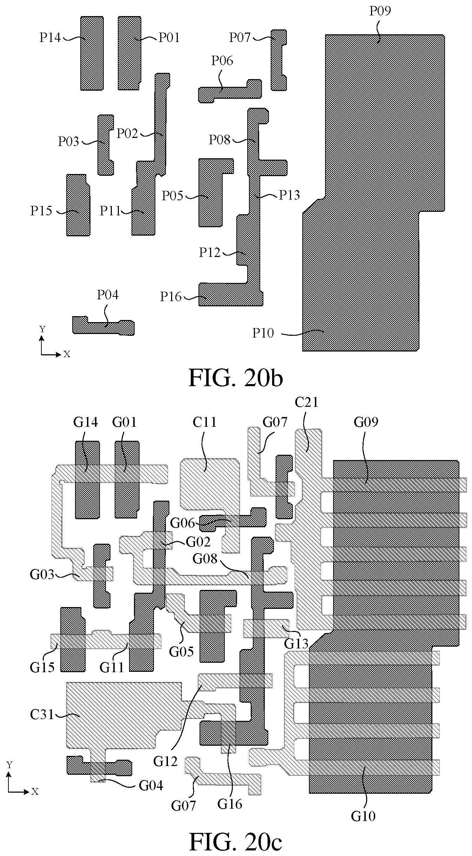

As shown in FIG. 20b, in order to form a schematic diagram of a planar structure diagram of the active layer of the first gate driving circuit GOA1 in the display substrate on the base substrate, the active layer may include an active layer P01 of the first transistor T1 to an active layer P16 of the sixteenth transistor T16, wherein an active layer P09 of the ninth transistor T9 and an active layer P10 of the tenth transistor T10 may form an integral structure, an active layer P02 of the second transistor T2 and an active layer P11 of the eleventh transistor T11 may form an integral structure, an active layer P08 of the eighth transistor T8, an active layer P13 of the thirteenth transistor T13, and an active layer P16 of the sixteenth transistor T16 may form an integral structure, and an active layer P01 of the first transistor T1, an active layer P03 of the third transistor T3 to an active layer P08 of the eighth transistor T8, an active layer P14 of the fourteenth transistor T14, and an active layer P15 of the fifteenth transistor T15 may be independently provided.

As shown in FIG. 20c, in order to a schematic diagram of a planar structure after forming the first conductive layer (which may be referred to as a Gate1 layer), the first conductive layer may include: a control electrode G01 of the first transistor T1 to a control electrode G16 of the sixteenth transistor T16, a first electrode plate C11 of the first capacitor C1, a first electrode plate C21 of the second capacitor C2, a first electrode plate C31 of the third capacitor C3; the first electrode plate C11 of the first capacitor C1 is connected to a control electrode G06 of the sixth transistor T6, the first electrode plate C21 of the second capacitor C2 is connected to a control electrode G09 of the ninth transistor T9, the first electrode plate C31 of the third capacitor C3 is connected to a control electrode G04 of the fourth transistor T4 and a control electrode G16 of the sixteenth transistor T16, the control electrode G01 of the fourteenth transistor T14 is connected to a control electrode G01 of the first transistor T1 and a control electrode G03 of the third transistor T3, a control electrode G02 of the second transistor T2 is connected to a control electrode of the eighth transistor G08, and a control electrode G11 of the eleventh transistor T11 connected to a control electrode G15 of the fifteenth transistor T15. In an exemplary implementation, channels of the first transistors T1 to sixteenth transistors T16 are formed in a region where the control electrode G01 of the first transistor T1 to the control electrode G 16 of the sixteenth transistor T16 are overlapping with the active layer P01 of the first transistor T1 to the active layer P16 of the sixteenth transistors T16, respectively.

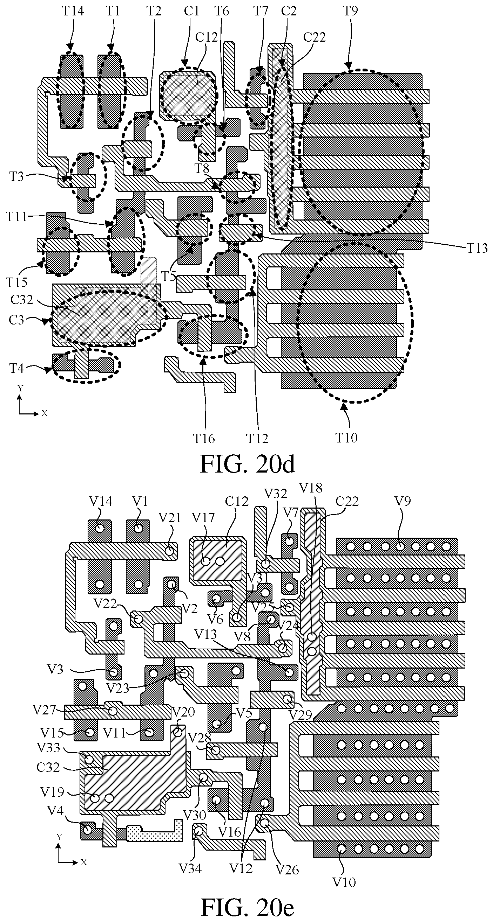

As shown in FIG. 20d, which is a schematic diagram of a planar structure after forming the second conductive layer (which may be referred to as a Gate2 layer), the second conductive layer may include a second electrode plate C12 of the first capacitor C1, a second electrode plate C22 of the second capacitor C2, and a second electrode plate C32 of the third capacitor C3; an orthographic projection of the second electrode plate C12 of the first capacitor C1 on the base substrate is at least partially overlapped with an orthographic projection of the first electrode plate C 11 of the first capacitor C1 on the base substrate, an orthographic projection of the second electrode plate C22 of the second capacitor C2 on the base substrate is at least partially overlapped with an orthographic projection of the first electrode plate C21 of the second capacitor C2 on the base substrate, and an orthographic projection of the second electrode plate C32 of the third capacitor C3 is at least partially overlapped with an orthographic projection of the first electrode plate C31 of the third capacitor C3 on the base substrate.

As shown in FIG. 20e, in order to form a schematic diagram of a planar structure of the first via hole layer, the first via hole layer may include a first via hole V1 to a thirty-fourth via hole V34, orthographic projections of the first via hole V1 to a sixteenth via hole V16 on the base substrate are at least partially overlapped with orthographic projections of the active layer P11 of the first transistor T1 to the active layer P16 of the sixteenth transistor T16 on the base substrate, respectively; orthographic projections of the seventeenth via hole V17 to the nineteenth via hole V19 on the base substrate are at least partially overlapped with orthogonal projections of the second electrode plate C12 of the first capacitor C1 to the second electrode plate C32 of the third capacitor C3 on the base substrate, respectively; an orthographic projection of the twentieth via hole V20 on the base substrate is at least partially overlapped with an orthographic projection of the second electrode plate C32 of the third capacitor C3 on the base substrate; orthographic projections of the twenty-first via hole V21 to the thirtieth via hole V30 on the base substrate are at least partially overlapped with the orthographic projections of the control electrode G01 of the first transistor T1, the control electrode G02 of the second transistor T2, the control electrode G05 of the fifth transistor T5, the control electrode G08 of the eighth transistor T8, the control electrode G09 of the ninth transistor T9, the control electrode G10 of the tenth transistor T10, the control electrode G11 of the eleventh transistor T11, the control electrode G12 of the eleventh transistor T12, the control electrode G13 of the thirteenth transistor T13, and the control electrode G16 of the sixteenth transistor T16 on the base substrate, respectively; orthographic projections of the thirty-first via hole V31 and the thirty-second via hole V32 on the base substrate are at least partially overlapped with orthographic projections of the control electrode G06 of the sixth transistor T6 and the control electrode G07 of the seventh transistor T7 on the base substrate, respectively; an orthographic projection of the thirty-third via hole V33 on the base substrate is at least partially overlapped with an orthographic projection of the first electrode plate C31 of the third capacitor C3 on the base substrate; and an orthographic projection of the thirty-fourth via hole V34 on the base substrate is at least partially overlapped with an orthographic projection of the control electrode G07 of the seventh transistor T7 on the base substrate.

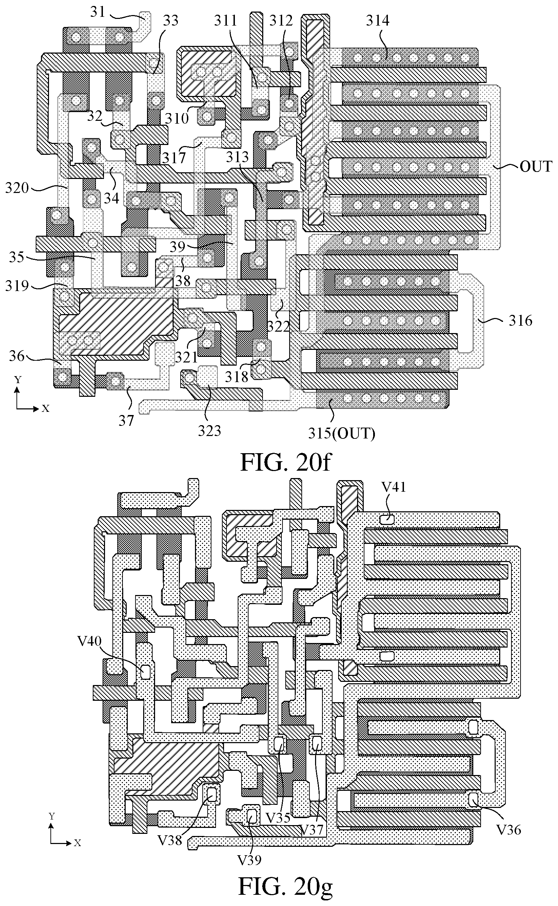

As shown in FIG. 20f, which is a schematic diagram of a planar structure after forming a first via hole layer and a third conductive layer (which may be referred to as the SD1 layer), respectively, the third conductive layer may include a first connection electrode 31 to a twenty-third connection electrode 323; the first connection electrode 31 may be electrically connected to the active layer P11 of the first transistor T1 and the active layer P04 of the fourth transistor T4 through the first via hole V1 and the fourteenth via hole V14, respectively, and the first connection electrode 31 may serve as a signal input terminal (STV) and as a first electrode of the first transistor T1 and a first electrode of the fourteenth transistor T14; the second connection electrode 32 may be electrically connected to the active layer P11 of the first transistor T1 and the control electrode G02 of the second transistor T2 through the first via hole V1 and the second via hole V22, respectively, and the second electrode 32 may serve as a second electrode of the first transistor T1; the third connection electrode 33 may be electrically connected to the active layer P02 of the second transistor T2 and the control electrode G01 of the first transistor T1 through the second via hole V2 and the twenty-first via hole V21, respectively, and the third connection electrode 33 may serve as the first electrode of the second transistor T2; the fourth connection electrode 34 may be electrically connected to the active layer P03 of the third transistor T3, the active layer P11 of the eleventh transistor T11, and the control electrode G05 of the fifth transistor T5 through the third via hole V3, the eleventh via hole V11, and the twenty-third via hole V23, respectively, and the fourth connection electrode 34 may serve as the second electrode of the third transistor T3 and the first electrode of the eleventh transistor T11; the fifth connection electrode 35 may be electrically connected to the active layer P03 of the third transistor T3, the control electrodes of the fifth transistor T5 and the eleventh transistor T11, and the control electrode G12 of the twelfth transistor T12 through the third via hole V3, the twenty-seventh via hole V27, and the twenty-eighth via hole V28, respectively, and the fifth connection electrode 35 may serve as the first electrode of the third transistor T3 and as an input terminal of the low level signal VGL; the sixth connection electrode 36 may be electrically connected to the active layer P04 of the fourth transistor T4 and the second electrode plate C32 of the third capacitor C3 through the fourth via hole V4 and the ninth via hole V9, respectively, and the sixth connection electrode 36 may serve as the second electrode of the fourth transistor T4; the seventh connection electrode 37 may be electrically connected to the active layer P04 of the fourth transistor T4 through the fourth via hole V4, and the seventh connection electrode 37 may serve as the first electrode of the fourth transistor T4; the eighth connection electrode 38 may be electrically connected to the active layer P05 of the fifth transistor T5 and the second electrode plate C32 of the third capacitor C3 through the fifth via hole V5 and the twentieth via hole V20, respectively, and the eighth connection electrode 38 may serve as the second electrode of the fifth transistor T5; the ninth connection electrode 39 may be electrically connected to the active layer P05 of the fifth transistor T5 through the fifth via hole V5, and the ninth connection electrode 39 may serve as the first electrode of the fifth transistor T5; the tenth connection electrode 310 may be electrically connected to the active layer P06 of the sixth transistor T6, the second electrode plate C12 of the first capacitor C1, and the active layer P07 of the seventh transistor T7 through the sixth via hole V6, the seventeenth via hole V17, and the seventh via hole V7, respectively, and the tenth connection electrode 310 may serve as the second electrode of the sixth transistor T6 and the first electrode of the seventh transistor T7; the eleventh connection electrode 311 may be electrically connected to the active layer P06 of the sixth transistor T6 and the control electrode G07 of the seventh transistor T7 through the sixth via hole V6 and the thirty-second via hole V32, respectively, and the eleventh connection electrode 311 may serve as the first electrode of the sixth transistor T6; the twelfth connection electrode 312 may be electrically connected to the active layer P07 of the seventh transistor T7, the control electrode of the ninth transistor T9, the first electrode plate C21 of the second capacitor C2, and the active layer P08 of the eighth transistor T8 through the seventh via hole V7, the twenty-fifth via hole V25, and the eighth via hole V8, respectively, and the twelfth connection electrode 312 may serve as the second electrode of the seventh transistor T7 and the first electrode of the eighth transistor T8; the thirteenth connection electrode 313 may be electrically connected to the active layers of the twelfth transistor T12 and the thirteenth transistor T13, and the control electrodes of the second transistor T2 and the eighth transistor T8, respectively, through the twelfth via hole V12 and the twenty-ninth via hole V29, and the thirteenth connection electrode 313 may serve as a first electrode of the twelfth transistor T12 and a second electrode of the thirteenth transistor T13; the fourteenth connection electrode 314 may be electrically connected to the active layer P09 of the ninth transistor T9, the active layer of the eighth transistor T8, and the active layer of the thirteenth transistor T13 through the ninth via hole V9 and the thirteenth via hole V13, respectively, and the fourteenth connection electrode 314 may serve as the first electrodes of the eighth transistor T8, the ninth transistor T9, and the thirteenth transistor T13 and may serve as an input terminal of the high-level signal VGH; the fifteenth connection electrode 315 may be electrically connected to the active layer P10 of the tenth transistor T10, and the active layer P09 of the ninth transistor T9 through the tenth via hole V10 and the ninth via hole V9, respectively, and the fifteenth connection electrode 315 may serve as the second electrode of the ninth transistor T9 and the second electrode of the tenth transistor T10 and may serve as a signal output terminal OUT, which is electrically connected to a signal input terminal STV of the next first gate driving circuit GOA1; the sixteenth connection electrode 316 may be electrically connected to the active layer P10 of the tenth transistor T10 through the tenth via hole V10, and the sixteenth connection electrode 316 may serve as the first electrode of the tenth transistor T10; the seventeenth connection electrode 317 may be electrically connected to the active layer P11 of the eleventh transistor T11 and the control electrode G06 of the sixth transistor T6 through the eleventh via hole V11 and the thirty-first via hole V31, respectively, and the seventeenth connection electrode 317 may serve as the second electrode of the eleventh transistor T11; the eighteenth connection electrode 318 may be electrically connected to the active layers of the sixteenth transistor T16 and the twelfth transistor T12, and the control electrode G10 of the tenth transistor T10 through the twelfth via hole V12 and the twenty-sixth via hole V26, respectively, and the eighteenth connection electrode 318 may serve as the second electrodes of the twelfth transistor T12 and the sixteenth transistor T16; the nineteenth connection electrode 319 may be electrically connected to the fifteenth transistor T15, and the first electrode plate C31 of the third capacitor C3 through the fifteenth via hole V15 and the thirty-third via hole V33, respectively, and the nineteenth connection electrode 319 may serve as the second electrode of the fifteenth transistor T15; the twentieth connection electrode 320 may be electrically connected to the active layer P14 of the fourteenth transistor T14 and the active layer P15 of the fifteenth transistor T15 through the fourteenth via hole V14 and the fifteenth via hole V15, respectively, and the twentieth connection electrode 320 may serve as the second electrode of the fourteenth transistor T14 and the first electrode of the fifteenth transistor T15; the twenty-first connection electrode 321 may be electrically connected to the active layer P16 of the sixteenth transistor T16, and the first electrode plate C31 of the third capacitor C3 through the sixteenth via hole V16 and the thirtieth via hole V30, respectively, and the twenty-first connection electrode 321 may serve as the first electrode of the sixteenth transistor T16; the twenty-second connection electrode 322 may be electrically connected to the control electrode G13 of the thirteenth transistor T13 through the twenty-ninth via hole V29, and the twenty-second connection electrode 322 may serve as an input terminal of the voltage signal VEL; and the twenty-third connection electrode 323 may be electrically connected to the control electrode G07 of the seventh transistor T7 through the thirty-fourth via hole V34.

As shown in FIG. 20g, which is a schematic diagram of a planar structure after forming the second via hole layer, the second via hole layer may include: a thirty-fifth via hole V35 to a forty-first via hole V41; an orthographic projection of the thirty-fifth via hole V35 on the base substrate is within a range of an orthographic projection of the ninth connection electrode 39 on the base substrate, an orthographic projection of the thirty-sixth via hole V36 on the base substrate is within a range of an orthographic projection of the sixteenth connection electrode 316 on the base substrate, an orthographic projection of the thirty-seventh via hole V37 on the base substrate is within a range of an orthographic projection of the twenty-second connection electrode 322 on the base substrate, an orthographic projection of the thirty-eighth via hole V38 on the base substrate is within a range of an orthographic projection of the seventh connection electrode 37 on the base substrate, and an orthographic projection of an thirty-ninth via hole V39 on the base substrate is within a range of an orthographic projection of the twenty-third connection electrode 323 on the base substrate; an orthographic projection of the fortieth via hole V40 on the base substrate is within a range of an orthographic projection of the fifth connection electrode 35 on the base substrate; and an orthographic projection of the forty-first via hole V41 on the base substrate is within a range of an orthographic projection of the fourteenth connection electrode 314 on the base substrate.

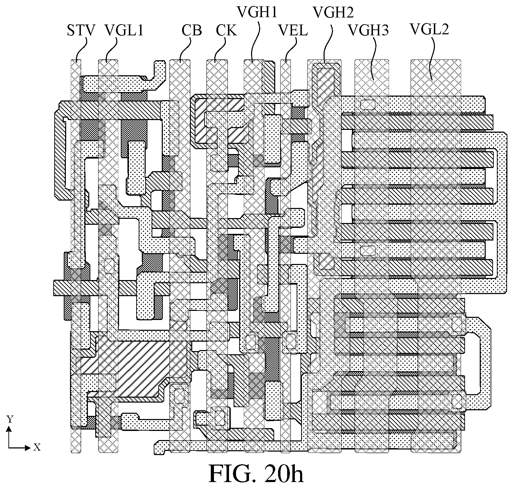

As shown in FIG. 20h, which is a schematic diagram of a planar structure after forming the fourth conductive layer (which may be referred to as the SD2 layer), the fourth conductive layer may include an input signal line STV, a first low-level signal line VGL1, a first clock signal line CB, a second clock signal line CK, a first high-level signal line VGH1, a second high-level signal line VGH2, a third high-level signal line VGH3, a second low-level signal line VGL2, and an input signal line STV, a first low-level signal line VGL1, a first clock signal line CB, a second clock signal line CK, a first high-level signal line VGH1, a second high-level signal line VGH2, and a third high-level signal line VGH3; the second low-level signal line VGL2 may be arranged at intervals along the first direction X and extend along the second direction Y; the input signal line STV is electrically connected to an input terminal of the first gate driving circuit GOA1 of the first stage to provide an input signal to the input terminal of the first gate driving circuit of the first stage; the first low-level signal line VGL2 may be electrically connected to the fifth connection electrode 35 through the fortieth via hole V40; the second low-level signal line VGL1 may be electrically connected to the sixteenth connection electrode 316 through the thirty-sixth via hole V36; the second level signal line VEL may be electrically connected to the twenty-second connection electrode 322 through the thirty-seventh via hole V37 to provide a voltage signal to the control electrode G13 of the thirteenth transistor T13; the first high-level signal line VGH1 may be electrically connected to the ninth connection electrode 39 through the thirty-fifth via hole V35 to provide a voltage signal to the first electrode of the fifth transistor T5; the second high-level signal line VGH2 and the third high-level signal VGH3 may be electrically connected to the fourteenth connection electrode 314 through the forty-first via hole V41 to provide a voltage signal to the first electrode of the ninth transistor T9, and the second high-level signal VGH2 in FIG. 20h may be electrically connected to the fourteenth connection electrode 314 of the first gate driving circuit GOA1 of the upper or lower stage through the forty-first via hole V41; the first clock signal line CB may be electrically connected to the seventh connection electrode 37 through the thirty-eighth via hole V38 to provide a clock signal to the first electrode of the fourth transistor T4; and the second clock signal line CK may be electrically connected to the twenty-third connection electrode 323 through the thirty-ninth via hole V39 to provide a clock signal to the control electrode of the seventh transistor T7. The first low-level signal line VGL1 and the second low-level signal line VGL2 may provide the same low-level signal VGL, and the first high-level signal line VGH1, the second high-level signal line VGH2, and the third high-level signal line VGH3 may provide the same high-level signal VGH.

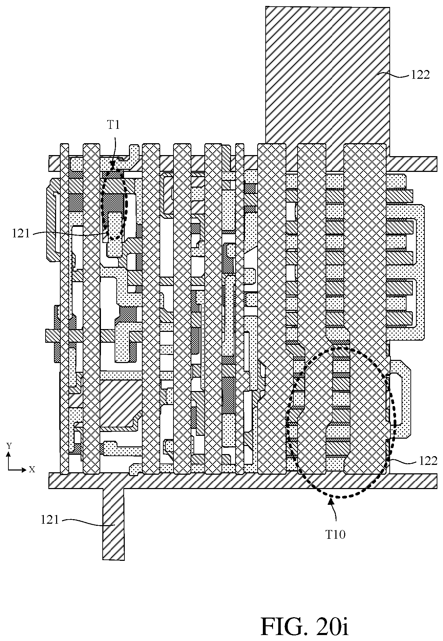

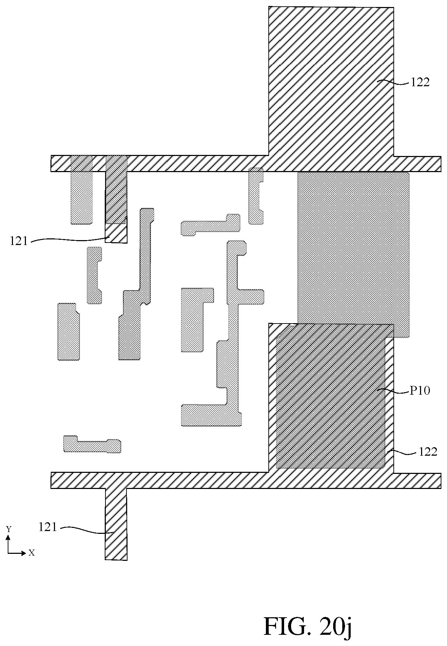

As shown in FIG. 20i, it is a schematic diagram of a structure in which a shielding structure layer 12 is provided between the base substrate and the driving circuit layer, and FIG. 20j is a schematic diagram of a planar structure in which an active layer is formed on the shielding structure layer 12. In the exemplary implementation, a first insulation layer is provided between the shielding structure layer 12 and the active layer, a second insulation layer is provided between the active layer and the first conductive layer, a third insulation layer is provided between the first conductive layer and the second conductive layer, a fourth insulation layer is provided between the second conductive layer and the third conductive layer, and a fifth insulation layer is provided between the third conductive layer and the fourth conductive layer; in the first via hole layer, the first via hole V1 to sixteenth via hole V16 penetrate through the second insulation layer to the fourth insulation layer, the seventeenth via hole V17 to twentieth via hole V20 penetrate through the fourth insulation layer, and the twenty-first via hole V21 to thirty-fourth via hole V34 penetrate through the third insulation layer and the fourth insulation layer; and in the second via hole layer, the thirty-fifth via hole V35 to the fortieth via hole V40 penetrate through the fifth insulation layer.

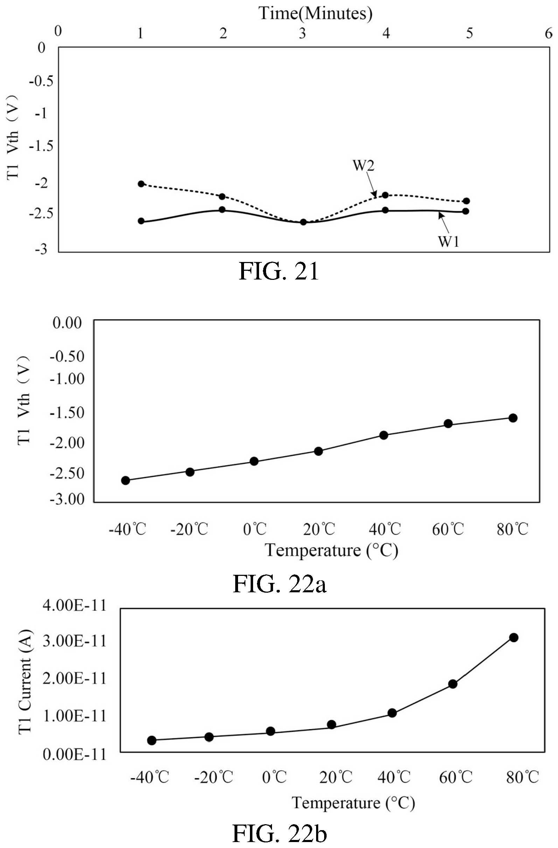

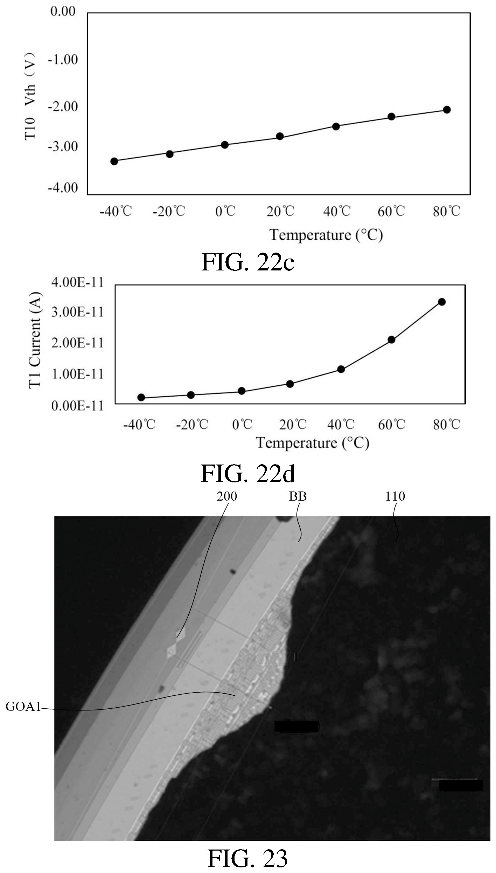

In an exemplary implementation, as shown in FIG. 21, which are characteristic curves of the first transistor T1 (the low-level output control transistor described above) shielded by the first structure layer 11 and not shielded by the first structure layer 11, the curve W1 is a characteristic curve of the first transistor in a case that the first transistor T1 is covered by the first structure layer 11; the curve W2 is a characteristic curve of the first transistor T1 in a case that the first transistor T1 is not covered by the first structure layer 11; as can be seen from FIG. 21, the characteristic of the first transistor T1 shielded by the first structure layer 11 is quite different from the characteristic of the first transistor T1 not shielded by the first structure layer 11. As can be seen from FIG. 21, a change in a threshold voltage Vth of the first crystal T1 over time in the curve W1 is small, and basically there is not much change; and a change in the threshold voltage Vth of the first crystal T1 over time in the curve W2 is relatively large. Therefore, in a case that the first transistors T1 in the plurality of the first gate driving circuits GOA1 are shielded in an inconsistent manner, the characteristics of the first transistors T1 are greatly different, and the first transistors T1 in the plurality of the first gate driving circuits GOA1 may be shielded in a consistent manner by the first structure layer 11 or the shielding structures (121, 122) in the above-described embodiment to prevent that the scan signals output from the plurality of the first gate driving circuits to the oxide transistor T2 in the display region AA from being inconsistent, and which may improve the display uniformity of the display region. In an exemplary implementation, as shown in FIGS. 22a to 22d, FIGS. 17a to 17e are characteristic change curves of the first transistor T1 (the low-level output control transistor described above) and the tenth transistor T10 (the low-level output transistor described above ) affected by temperature, and FIG. 22a is a change curve of a threshold voltage Vth of the first transistor T1 as the temperature changes, and the threshold voltage Vth of the first transistor T1 increases as the temperature rises; FIG. 22b is a change curve of a current of the first transistor T1 as the temperature changes, and the current of the first transistor T1 increases as the temperature rises; FIG. 22c is a change curve of a threshold voltage Vth of the tenth transistor T10 as the temperature changes, and the threshold voltage Vth of the tenth transistor T10 increases as the temperature rises; and FIG. 22d is a change curve of a current of the tenth transistor T10 as the temperature changes, and the current of the tenth transistor T10 increases as the temperature rises. As can be seen from FIGS. 22a to 22d, the characteristics of the first transistor T1 and the tenth transistor T10 are greatly affected by temperature. Therefore, in a case that the first transistors T1 and the tenth transistors T10 in the plurality of the first gate driving circuits GOA1 are shielded in an inconsistent manner, the characteristics of the first transistors T1 and the tenth transistors T10 are greatly different, and the first transistors T1 and the tenth transistors T10 in the plurality of the first gate driving circuits GOA1 may be shielded in a consistent manner by the first structure layer 11 or the shielding structures (121, 122) in the above-described embodiment to prevent that the scan signals output from the plurality of the first gate driving circuits GOA1 to the oxide transistor T2 in the display region AA from being inconsistent, and which may improve the display uniformity of the display region.

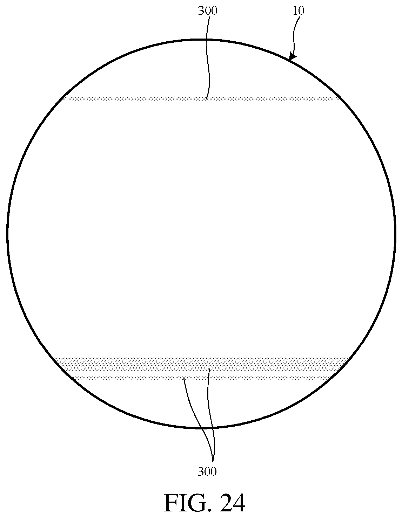

In an exemplary implementation, as shown in FIG. 23, in order to provide a cut alignment mark (MARK) 200 on the display substrate, the first structure layer 11 is provided with an opening 1101 at the alignment mark position, so that the first driving circuit GOA1 at a position of the opening 1101 is not covered by the first structure layer 11, and all of the first driving circuit GOA1 at other positions is covered by the first structure layer 11, which will easily lead to the occurrence of the transverse stripes 300 as shown in FIG. 24. By adopting the above-described scheme, a plurality of first driving circuits GOA1 are shield by the protective structure 110 in a consistent manner, which may avoid a defect of the transverse stripes.

In the exemplary implementation, in the first gate driving circuit GOA1 described in FIG. 17, the first transistors T1 and the tenth transistors T10 are greatly affected by factors such as temperature, light, and the like. The first transistors T1 and the tenth transistors T10 may be shielded in a manner consistent through the first structure layer 11 or the shielding structures (121, 122), so as to avoid the occurrence of transverse stripes. In the exemplary implementation, the plurality of first gate driving circuits GOA1 are arranged to provide scan signals to the second transistors T2 (oxide transistors) of the pixel circuits of the plurality of rows of sub-pixels in the display region AA. The oxide transistors T2 in the pixel driving circuit are greatly affected by the change of the scan signals output from the gate driving circuit GOA, and the low temperature polysilicon transistor in the pixel driving circuit is not significantly affected by the change of the scan signals output from the gate driving circuit GOA. Therefore, in embodiments of the present disclosure, the shielding manner of the plurality of first driving circuits GOA1 that provide the scan signals to the oxide transistors T2 is set to be consistent, so as to avoid the occurrence of transverse stripes in the display region AA in the operating state.

The present disclosure also provides a display module, as shown in FIGS. 6, 8a, 18, 19 and 20i, which may include a display substrate 10, and on a plane parallel to the display substrate, the display substrate 10 may include a display region AA and a bezel region BB, which may be located around the display region AA and is provided with first gate driving circuits GOA1 of at least one type; the number of the first gate driving circuits GOA1 of the same type is a plurality, and the first gate driving circuit GOA1 includes a plurality of transistors; in a direction Z perpendicular to a plane where the display substrate is located, the display substrate 10 may include a light exiting side S1 and a backlight side S2, a shielding structure layer 12 is provided on a side of the first gate driving circuit GOA1 away from the light exiting side S2, and ranges of at least a part of the transistors in the plurality of first gate driving circuits GOA1 of the same type shielded by the shielding structure layer 12 are consistent.

In an exemplary implementation, a plurality of first gate driving circuits GOA1 of the same type are arranged along an extension direction of the bezel region BB.

In the exemplary implementation, ranges of at least a part of the transistors in the plurality of first gate driving circuits GOA1 of the same type shielded by the shielding structure layer 12 are consistent, which may be absolute consistent in the shielding range, or may be roughly consistent in the shielding range, for example, the shielding range may have a deviation of about 5% to 15%.

In the exemplary implementation, the range of the plurality of first gate driving circuits GOA1 of the same type shielded by the shielding structure layer 12 are consistent, which may be consistent in a overlapping region between at least a part of the transistors in the plurality of first gate driving circuits GOA1 of the same type and an orthographic projection of the shielding structure layer 12 on the base substrate.

In an exemplary implementation, the display region AA may include a plurality of rows of sub-pixels Pxij, and the sub-pixel Pxij at least includes a pixel driving circuit, which includes at least one type of an oxide transistor; and the first gate driving circuit GOA1 is electrically connected to a control electrode of the at least one type of the oxide transistor in at least one row of sub-pixels and is arranged to provide scan signals to the at least one type of the oxide transistor in the at least one row of sub-pixels. As shown in FIG. 5, the second transistor T2 in the pixel driving circuit is an oxide transistor.

In an exemplary implementation, the plurality of transistors in the first gate driving circuit GOA1 at least include a low-level output transistor (e.g., the tenth transistor T10 in FIGS. 17a to 17e) and a low-level output control transistor (e.g., the first transistor T1 in FIGS. 17a to 17e), the low-level output transistor is configured to output low-level signals to the at least one type of the oxide transistor in at least one row of sub-pixels under the control of the low-level output control transistor; and
ranges of low-level output transistors in a plurality of first gate driving circuits of the same type shielded by the shielding structure layer are consistent; and ranges of low-level output control transistors in a plurality of first gate driving circuits of the same type shielded by the shielding structure layer are consistent.

In an exemplary implementation, as shown in FIG. 18, the shielding structure layer 12 may at least include one of the first shielding structure 121 and the second shielding structure 122; and
the number of the first shielding structures 121 is a plurality, and the plurality of first shielding structures 121 are respectively configured to shield low-level output control transistors in a plurality of first gate driving circuits GOA1 of at least one type; and the number of the second shielding structures 122 is a plurality, and the plurality of second shielding structures 122 are respectively configured to shield low-level output transistors in a plurality of first gate driving circuits GOA1 of at least one type.

In the exemplary implementation, the low-level output control transistors in different first gate driving circuits GOA1 of the same type are shielded by the first shielding structure 121 in a consistent manner, so that characteristics of the low-level output control transistors in the plurality of first gate driving circuits GOA1 are kept as consistent as possible to prevent the display region AA from having transverse stripes due to the inconsistency of characteristics of the low-level output control transistors in the plurality of first gate driving circuits; and the low-level output transistors in the different first gate driving circuits GOA1 of the same type are shielded by the second shielding structure 122 in a consistent manner, so that characteristics of the low-level output transistors in the plurality of first gate driving circuits GOA1 are kept as consistent as possible to prevent the display region AA from having transverse stripes due to the inconsistency of the characteristics of the low-level output transistors in the plurality of first gate driving circuits GOA1.

In an exemplary implementation, the display substrate may also include a substrate, and in a direction Z perpendicular to a plane on which the display substrate is located, the shielding structure layer 12 may be located between the base substrate and the first gate driving circuit GOA1, wherein an orthographic projection of the first shielding structure 121 on the base substrate covers an orthographic projection of the corresponding low-level output control transistors on the base substrate, and an orthographic projection of the second shielding structure 122 on the base substrate covers an orthographic projection of the corresponding low-level output transistors on the base substrate.

In an exemplary implementation, as shown in FIG. 18, the shielding structure layer 12 may also include a third shielding structure 123, whose orthographic projection on the base substrate covers the third transistor T3 (the third transistor T3 shown in FIG. 5) in the pixel driving circuit, wherein on a plane parallel to the display substrate, the first shielding structure 121 and the second shielding structure 122 are located in the bezel region BB, and the third shielding structure 123 is located in the display region AA. In an embodiment of the present disclosure, the shielding structure located in the bezel region BB may be formed with the shielding structure located in the display region AA through a same process, and without increasing the process flow, providing a shielding structure in the bezel region BB may solve a defect that the brightness of the display region is not uniform due to the inconsistency of transistor characteristics in the first gate driving circuit GOA1.

The present disclosure further provides a display apparatus, including the display module according to any of the aforementioned embodiments. The display apparatus may be any product or component with a display function, such as a wearable device (for example, a watch), a mobile phone, a tablet computer, a television, a display, a laptop computer, a digital photo frame, or a navigator and the like.

An embodiment of the present disclosure provides a display module and a display apparatus, and the display module includes a display substrate and a first structure layer. The first structure layer is located on a backlight side of the display substrate, and ranges of at least a part of the transistors in a plurality of first gate driving circuits of the same type located in the bezel region of the display substrate covered by an orthographic projection of the first structure layer on the display substrate are consistent, which may overcome a technical problem of uneven brightness of the display module.

The embodiments of the present disclosure, that is, features in the embodiments, may be combined with each other to obtain a new embodiment in a situation of no conflicts.

Although the implementations disclosed in the embodiments of the present disclosure are described above, contents are only implementations for facilitating understanding of the embodiments of the present disclosure, but are not intended to limit the embodiments of the present disclosure. Any person skilled in the art to which the embodiments of the present disclosure pertain may make any modifications and variations in forms and details of implementation without departing from the spirit and the scope disclosed in the embodiments of the present disclosure. Nevertheless, the scope of patent protection of the embodiments of the present disclosure shall still be subject to the scope defined by the appended claims.

## Claims

1. A display module comprising a display substrate and a first structure layer, wherein
on a plane parallel to the display substrate, the display substrate comprises a display region and a bezel region;
the bezel region is located around the display region, wherein the bezel region is provided with first gate driving circuits of at least one type, the number of first gate driving circuits of the same type is a plurality, and the first gate driving circuit comprises a plurality of transistors;
in a direction perpendicular to a plane where the display substrate is located, the display substrate comprises an light exiting side and a backlight side, wherein the first structure layer is arranged on the backlight side of the display substrate, an orthographic projection of the first structure layer on the display substrate covers at least a part of the display region, and ranges of at least a part of the transistors in a plurality of first gate driving circuits of the same type covered by the orthographic projection of the first structure layer on the display substrate are consistent.

2. The display module according to claim 1, wherein
the display region comprises a plurality of rows of sub-pixels, and the sub-pixel at least comprises a pixel driving circuit, which comprises at least one type of an oxide transistor;
the first gate driving circuit is electrically connected to a control electrode of the at least one type of the oxide transistor in at least one row of sub-pixels and configured to provide scan signals to the at least one type of the oxide transistor in the at least one row of sub-pixels.

3. The display module according to claim 2, wherein
the plurality of transistors in the first gate driving circuit at least comprise a low-level output transistor and a low-level output control transistor, and the low-level output transistor is configured to output low-level signals to the at least one type of the oxide transistor in the at least one row of sub-pixels under the control of the low-level output control transistor;
ranges of low-level output transistors in a plurality of first gate driving circuits of the same type covered by the orthographic projection of the first structure layer on the display substrate are consistent; and ranges of low-level output control transistors in a plurality of first gate driving circuits of the same type covered by the orthographic projection of the first structure layer on the display substrate are consistent.

4. The display module according to any one of claims 1 to 3, wherein there is no overlapping area between the orthographic projection of the first structure layer on the display substrate and a plurality of first gate driving circuits of at least one type.

5. The display module according to claim 4, wherein an orthographic projection of an edge of the first structure layer on the display substrate is located in a first region; on a plane parallel to the display substrate, the first region is located between edges of the plurality of first gate driving circuits of the at least one type close to the display region and an edge of the display region close to the bezel region, and the orthographic projection of the first structure layer on the display substrate covers the display region; or
the orthographic projection of the first structure layer on the display substrate is not overlapped with the bezel region, and the orthographic projection of the first structure layer on the display substrate is located within a range of the display region or overlapped with the display region.

6. The display module according to claim 4, wherein on a plane parallel to the display substrate and along a direction from the display region to the bezel region, a distance between an edge of the first structure layer and an edge of the display substrate is 700 microns to 1200 microns, which is greater than a distance between edges of first gate driving circuits of at least one type close to the display region and the edge of the display substrate.

7. The display module according to claim **1,** wherein an orthographic projection of the first structure layer on the display substrate covers the display region and a plurality of first gate driving circuits of at least one type.

8. The display module according to claim 7, wherein
the bezel region is also provided with second gate driving circuits of at least one type, the number of the second gate driving circuits of the same type is a plurality;
on a plane parallel to the display substrate, the plurality of second gate driving circuits of the same type are arranged along an extension direction of the bezel region, and along an direction from the display region to the bezel region, the plurality of second gate driving circuits of at least one type are located between the plurality of first gate driving circuits of the at least one type and the display region.

9. The display module according to claim 8, wherein on a plane parallel to the display substrate and in a direction from the display region to the bezel region, a distance between an edge of the first structure layer and an edge of the display substrate is 100 microns to 350 microns, which is less than a distance between edges of first gate driving circuits of at least one type away from the display region and the edge of the display substrate.

10. The display module according to claim 7, wherein
the bezel region is also provided with second gate driving circuits of at least one type, the number of the second gate driving circuits of the same type is a plurality;
on a plane parallel to the display substrate, the plurality of second gate driving circuits of the same type are arranged along an extension direction of the bezel region, and along an direction from the display region to the bezel region, the plurality of second driving circuits of at least one type are located on a side of the plurality of first driving circuits of the at least one type away from the display region.

11. The display module according to claim 10, wherein on a plane parallel to the display substrate and in a direction from the display region to the bezel region, a distance between an edge of the first structure layer and an edge of the display substrate is 500 microns to 700 microns, which is less than a distance between edges of first gate driving circuits of at least one type away from the display region and the edge of the display substrate.

12. The display module according to any one of claims 1 to 3 and claims 10-11, wherein
the first structure layer comprises a first connection structure layer, a buffer structure layer, and a heat dissipation structure layer which are arranged on the backlight side sequentially; and
an orthographic projection of the heat dissipation structure layer on the display substrate is not overlapped with a plurality of first gate driving circuits of at least one type, or the orthographic projection of the heat dissipation structure layer on the display substrate covers a plurality of first gate driving circuits of at least one type.

13. The display module according to claim 3, wherein the orthographic projection of the first structure layer on the display substrate at least covers at least one of the low-level output transistor and the low-level output control transistor in a plurality of first gate driving circuits of at least one type.

14. The display module according to claim 13, wherein
on a plane parallel to the display substrate and along a direction from the display region to the bezel region, the low-level output control transistor is located on a side of the low-level output transistor away from the display region, a length dimension of first gate driving circuits of at least one type is 120 microns to 150 microns, and the low-level output control transistor and the low-level output transistor are located on both sides of a centerline of the first gate driving circuit along an extension direction of the bezel region;
in a structure in which the orthographic projection of the first structure layer on the display substrate at least covers low-level output transistors and low-level output control transistors in a plurality of first gate driving circuits of at least one type, a length dimension of the orthographic projection of the first structure layer on the display substrate covering the first gate driving circuits of the at least one type is 100 microns to 150 microns along a direction from the display region to the bezel region; and
in a structure in which the orthographic projection of the first structure layer on the display substrate at least covers low-level output transistors in a plurality of first gate driving circuits of at least one type, a length dimension of the orthographic projection of the first structure layer on the display substrate covering the first gate driving circuits of the at least one type is 40 microns to 95 microns along a direction from the display region to the bezel region.

15. The display module according to claim 13 or 14, wherein
the bezel region is also provided with second gate driving circuits of at least one type, and on a plane parallel to the display substrate, a plurality of second gate driving circuits of the same type are arranged along an extension direction of the bezel region; and
in a direction from the display region to the bezel region, the plurality of second gate driving circuits of the at least one type are located on a side of the plurality of first gate driving circuits of the at least one type away from the display region, or the plurality of second gate driving circuits of the at least one type are located between the plurality of first gate driving circuits of the at least one type and the display region.

16. The display module according to claim 3, wherein
the display substrate comprises a shielding structure layer;
in a direction perpendicular to a plane on which the display substrate is located, the shielding structure layer is located on a side of the first gate driving circuit away from the light exiting side, and the shielding structure layer at least comprises at least one shielding structure of a first shielding structure and a second shielding structure;
the number of the first shielding structures is a plurality, and the plurality of first shielding structures are respectively configured to shield low-level output control transistors in a plurality of first gate driving circuits of at least one type; and the number of the second shielding structures is a plurality, and the plurality of second shielding structures are respectively configured to shield low-level output transistors in a plurality of first gate driving circuits of at least one type.

17. A display module comprising a display substrate, wherein
on a plane parallel to the display substrate, the display substrate comprises a display region and a bezel region, which is located around the display region and is provided with first gate driving circuits of at least one type;
the number of first gate driving circuits of the same type is a plurality, and the first gate driving circuit comprises a plurality of transistors;
in a direction perpendicular to a plane on which the display substrate is located, the display substrate comprises a light exiting side and a backlight side, and a shielding structure layer is provided on a side of the first gate driving circuit away from the light exiting side; and
ranges of at least a part of transistors of a plurality of first gate driving circuits of the same type shielded by the shielding structure layer are consistent.

18. The display module according to claim 17, wherein
the display region comprises a plurality of rows of sub-pixels, and the sub-pixel at least comprises a pixel driving circuit, which comprises at least one type of an oxide transistor;
the first gate driving circuit is electrically connected to a control electrode of the at least one type of the oxide transistor in at least one row of sub-pixels and configured to provide scan signals to the at least one type of the oxide transistor in the at least one row of sub-pixels.

19. The display module according to claim 18, wherein
a plurality of transistors in the first gate driving circuit at least comprise a low-level output transistor and a low-level output control transistor, and the low-level output transistor is configured to output a low-level signal to the at least one type of the oxide transistor in the at least one row of sub-pixels under the control of the low-level output control transistor; and
ranges of low-level output transistors in a plurality of first gate driving circuits of the same type shielded by the shielding structure layer are consistent; and ranges of low-level output control transistors in a plurality of first gate driving circuits of the same type shielded by the shielding structure layer are consistent.

20. The display module according to claim 19, wherein
the shielding structure layer at least comprises at least one shielding structure of a first shielding structure and a second shielding structure;
the number of the first shielding structures is a plurality, and the plurality of first shielding structures are respectively configured to shield low-level output control transistors in a plurality of first gate driving circuits of at least one type; and
the number of the second shielding structures is a plurality, and the plurality of second shielding structures are respectively configured to shield low-level output transistors in a plurality of first gate driving circuits of at least one type.

21. A display apparatus comprising a display module according to any one of claims 1 to 16, or comprising a display module according to any one of claims 17 to 20.
